# FASCICULE DE BREVET EUROPEEN

(11) **EP 1 523 803 B1**
(45) Date de publication et mention de la délivrance du brevet: **03.11.2010**
(21) Numéro de dépôt: 03748202.3
(22) Date de dépôt: 04.07.2003
(51) Int. Cl.: H02P 9/30

(54) **MODULE DE CONTROLE ET DE PUISSANCE D'UNE ALTERNO-DEMARREUR INTEGRABLE**
STEUER- UND LEISTUNGSMODUL EINER INTEGRIERTEN ANLASSER-LICHTMASCHINE
CONTROL AND POWER MODULE FOR INTEGRATED ALTERNATOR-STARTER

(30) Priorité: 04.07.2002 FR 0208420; 18.06.2003 FR 0307378
(43) Date de publication de la demande: 20.04.2005
(73) Titulaire: VALEO EQUIPEMENTS ELECTRIQUES MOTEUR, 94017 Créteil (FR)
(72) Inventeur: PIERRET, Jean-Marie, F-75012 Paris (FR); PFIFFER, Jean, Julien, F-91230 Montgeron (FR); TAUVRON, Fabrice, F-91200 Athis-Mons (FR)
(86) Numéro de dépôt international: PCT/FR2003/002092
(87) Numéro de publication internationale: WO 2004/006423

(56) Documents cités:
- EP-A- 0 357 183
- EP-A- 0 660 501
- EP-A- 1 134 886

## Description

### Domaine de l'invention

L'invention concerne une machine électrique tournante et réversible, telle qu'un alternateur-démarreur, destinée notamment d'une part, à alimenter en électricité le réseau de bord d'un véhicule automobile et à charger la batterie de ce véhicule et d'autre part à démarrer le moteur thermique du véhicule automobile. L'invention concerne plus particulièrement un module de contrôle et puissance destiné à commander une telle machine.

### Etat de la technique

Dans un véhicule automobile, l'alternateur permet de transformer un mouvement de rotation du rotor inducteur, entraîné par le moteur thermique du véhicule, en un courant électrique induit dans les bobinages du stator. L'alternateur peut aussi être réversible et constituer un moteur électrique, ou machine électrique tournante, permettant d'entraîner en rotation, via l'arbre de rotor, le moteur thermique du véhicule. Cet alternateur réversible est appelé alterno-démarreur, ou alternateur-démarreur. Il permet de transformer l'énergie mécanique en énergie électrique et vice versa. Ainsi, un alterno-démarreur peut démarrer le moteur thermique du véhicule automobile, ou encore, fonctionner en mode moteur pour entraîner le véhicule automobile. En général, le stator comporte trois bobinages, de sorte que l'alternateur est de type triphasé. En variante, l'alternateur est du type hexaphasé et peut être bobiné avec des barres de conducteurs formant des épingles. Lorsque l'alterno-démarreur fonctionne en mode démarreur ou en mode moteur, il doit transmettre au moteur thermique un couple très élevé.

Cette machine de type polyphasé et réversible fonctionne donc en alternateur pour, notamment, charger la batterie du véhicule et en démarreur pour entraîner le moteur à combustion interne, dit aussi moteur thermique, du véhicule automobile pour son démarrage.

A cet effet, une unité de puissance connectée sur les phases de l'induit de l'alternateur, sert de pont de commande de ces phases en mode moteur et fait office de pont redresseur lorsque l'alternateur-démarreur fonctionne en mode alternateur.

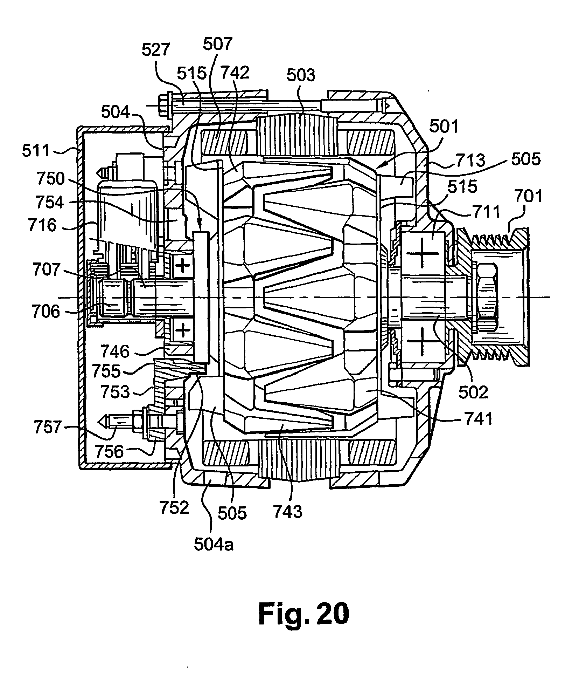

La figure 20 représente une machine électrique tournante formant alternateur-démarreur selon l'art antérieur, tel que décrit dans le document WO 01/69762.

Sur cette figure, la partie droite correspond à l'avant de la machine et la partie gauche à l'arrière de la machine. Cette machine tournante formant alternateur comprend :
- un rotor 743 bobiné constituant l'inducteur associé classiquement à deux bagues collectrices 706, 707 et deux balais par lesquels est amené le courant d'excitation ;
- un stator polyphasé 503 portant plusieurs bobines ou enroulements, constituant l'induit 507, qui sont connectés en étoile ou en triangle dans le cas le plus fréquent d'une structure triphasée et qui délivrent vers le pont redresseur, en fonctionnement alternateur, la puissance électrique convertie.

Le pont est relié aux différentes phases de l'induit et est monté entre la masse et une borne d'alimentation de la batterie. Ce pont présente, par exemple, des diodes associées à des transistors de type MOSFET.

Le fonctionnement en mode moteur d'un tel alternateur s'effectue en imposant, par exemple, un courant continu dans l'inducteur et en délivrant de manière synchrone, sur les phases du stator, des signaux déphasés de 120°, idéalement sinusoïdaux mais éventuellement trapézoïdaux ou carrés.

Ce pont redresseur en mode alternateur, et de commande en mode moteur, est piloté par une unité de contrôle. L'unité de puissance, constituée par le pont de redressement et de commande, et l'unité de contrôle constitue un module de contrôle et de puissance implanté à l'extérieur de la machine électrique tournante à laquelle elle est reliée par un moyen de liaison électrique aux bornes de sortie des phases du stator.

Il est, en outre, prévu des moyens pour le suivi de la position angulaire du rotor pour, en mode moteur électrique, injecter au bon moment du courant électrique dans le bobinage concerné du stator.

Ces moyens, avantageusement de type magnétique, envoient des informations à l'unité de contrôle et sont décrits par exemple dans les documents FR-2 807 231 et FR 2 806 223.

Ces moyens comportent donc une cible calée 750 en rotation sur le rotor ou la poulie 701 de la machine et au moins un capteur 752 du type à effet Hall ou magnéto-résistif détectant le passage de la cible, avantageusement du type magnétique.

De préférence, au moins trois capteurs 752 sont prévus, ceux-ci étant portés par le palier avant 713 ou arrière 504 que comporte la machine électrique tournante pour supporter, de manière fixe, le stator et, à rotation, le rotor.

Le porte-capteur 753, ici en matière plastique, présente des portions 755 d'orientation axiale. Ces portions 755 traversent le palier 504 à la faveur ici d'un trou 754. Les capteurs 752 sont solidaires des portions 755 et sont implantés radialement entre la cible 750 et les pales 505 en étant très proches de la cible 750. Le porte capteur est monté sur un boulon de fixation 757.

Les connexions électriques des capteurs 752 sont logées dans le porte-capteurs 753 fixé à l'aide de deux oreilles 756 sur le fond du palier arrière 504 du côté opposé à la cible 750 et au rotor 743.

Le porte-balais 716 est fixé sur la même face du fond du palier arrière 504 à l'aide de boulons et d'oreilles non référencés.

Le porte-balais 716 comporte de manière connue deux cages pour le guidage de balais coopérant chacun avec une bague collectrice 706, 707 rapportée sur l'extrémité arrière de l'arbre 502. Les balais sont soumis à l'action de ressorts logés dans les cages.

On souhaite, dans certains cas, améliorer les performances de démarrage d'un alternateur-démarreur. Ainsi, il est possible de surexciter le rotor pour obtenir plus de couple au démarrage.

Cette surexcitation peut être réalisée par une surtension aux bornes du bobinage d'excitation et/ou une surintensité dans le bobinage d'excitation par rapport à un alternateur conventionnel.

Ceci peut être réalisé à l'aide d'un survolteur électronique surexcitant le bobinage du rotor uniquement en mode démarrage.

Cette machine a ici la structure d'un alternateur classique, par exemple, du type de celui décrit dans le document EP-A-0 515 259 auquel on se reportera pour plus de précisions.

Les roues polaires 741, 742 sont trouées pour le passage à force de l'arbre 502. Plus précisément, l'arbre 502 est plus dur que les roues polaires 741, 742 pour fixation de celles-ci par ses portions molletées.

Cet arbre 502 s'étend de part et d'autre du rotor 743 et forme un sous-ensemble avec celui-ci.

Les roues polaires, par l'intermédiaire de leur flasque, portent à fixation, ici par soudage électrique, chacune un ventilateur 515 avec des pales 505.

Cette machine est donc à ventilation interne (refroidissement par air), son rotor portant au moins à l'une de ses extrémités axiales un ventilateur 515. En variante la machine est refroidie par eau.

Plus précisément le rotor est un rotor à griffes 743 avec des roues polaires 741, 742 portant à leur périphérie externe des dents d'orientation axiale et de forme trapézoïdale. Les dents d'une roue polaire sont dirigées vers les dents de l'autre roue polaire, lesdites dents de forme globalement trapézoïdale étant réparties de manière imbriquée d'une roue polaire à l'autre.

Bien entendu, comme décrit par exemple dans le document FR-A-2 793 085, des aimants permanents peuvent être intercalés entre les dents des roues polaires pour augmenter le champ magnétique.

Le rotor porte un bobinage d'excitation entre les flasques de ses roues polaires. Ce bobinage comporte un élément électriquement conducteur qui est enroulé avec formation de spires. Ce bobinage est un bobinage d'excitation qui, lorsqu'il est activé, magnétise le rotor pour créer, à l'aide des dents, des pôles magnétiques. Les extrémités du bobinage du rotor sont reliées chacune à une bague collectrice sur chacune desquelles frotte un balai. Les balais sont portés par un porte-balais solidaire du palier arrière de la machine portant centralement un roulement à billes supportant à rotation l'extrémité arrière de l'arbre portant à solidarisation le rotor.

L'extrémité avant de l'arbre est supportée à rotation par un roulement à billes 711 porté par le palier avant 713 de la machine. L'extrémité avant de l'arbre porte à l'extérieur de la machine une poulie 701 appartenant à un dispositif de transmission de mouvement comportant au moins une courroie en prise avec la poulie. Le dispositif de transmission de mouvement établit une liaison entre la poulie et un organe, tels qu'une autre poulie, entraîné en rotation par le moteur à combustion interne du véhicule.

De plus un capot arrière 511 est monté sur le palier arrière 504, notamment pour protéger le porte-balais, en sorte que lesdits moyens de suivi sont mieux protégés et plus faciles à implanter.

Lorsque la machine - ici un alternateur-démarreur - fonctionne en mode alternateur, c'est-à-dire comme générateur électrique, la poulie 701 est entraînée en rotation par le moteur à combustion interne du véhicule via au moins la courroie précitée. Lorsque la machine fonctionne en mode démarreur, c'est-à-dire en moteur électrique, la poulie entraîne en rotation le moteur du véhicule via la courroie.

Les paliers avant et arrière, ajourés pour la ventilation interne de la machine, sont reliés entre eux, par exemple à l'aide de tirants 527, et appartiennent au support de la machine destiné à être fixé sur une partie fixe du véhicule. Ce support porte de manière fixe à sa périphérie externe le stator constitué usuellement par un paquet de tôles 508 dotées d'encoches pour le montage des bobines ou plus généralement des enroulements du stator dont les sorties sont reliées au pont redresseur et de commande précité.

Les bobines ou enroulements du stator sont formés par des fils ou des enroulements en barres comme décrit par exemple dans le document WO92/06527; les barres peuvent être de section rectangulaire.

Le stator entoure le rotor, dont les balais sont reliés à un régulateur de l'alternateur pour maintenir la tension de l'alternateur à une tension voulue ici par exemple de l'ordre de 14V, pour une batterie de 12V.

Le module de contrôle et de puissance et le régulateur sont ici montés dans un boîtier électronique implanté à l'extérieur de la machine électrique tournante. Le régulateur peut également être intégré dans l'unité de contrôle du module de contrôle et de puissance qui est implanté à l'extérieur. Ce boîtier porte des moyens de commutation, comportant des interrupteurs de puissance, une unité de commande et un circuit de surexcitation. Le circuit de surexcitation est actif en mode démarrage pour rendre maximal le couple de démarrage de l'alternateur-démarreur et démarrer plus aisément le moteur à combustion interne, dit aussi moteur thermique, du véhicule automobile, soit lors d'un démarrage à froid, soit lors d'un redémarrage après par exemple un arrêt à un feu rouge, le moteur ayant été coupé pour réduire à la consommation de carburant et réaliser ainsi une fonction dite de «Stop and GO».

Ce circuit de surexcitation reçoit en entrée la tension de réseau de bord délivrée par la batterie et/ou l'alternateur et délivre aux bornes du bobinage d'excitation une tension supérieure à cette tension de réseau de bord.

Le régulateur peut comporter des moyens qui permettent, dans le cas où l'alternateur-démarreur se déchargerait sur le réseau de bord en étant déconnecté par rapport à la batterie (cas de « load dump » selon la terminologie anglo-saxonne généralement utilisée par l'homme du métier), de commander immédiatement l'ouverture d'un commutateur de puissance qui alimente la bobine d'excitation, afin de réaliser une démagnétisation rapide de l'alternateur, notamment de son rotor.

Actuellement, il est classique de réaliser une unité de puissance dans laquelle le pont redresseur comporte des transistors de puissance connectés pour former un pont d'interrupteurs, et dans lequel les transistors sont commandés en synchronisme avec le courant présent dans un enroulement induit de l'alternateur (redressement synchrone). Cependant, il est nécessaire de piloter les transistors au moyen d'une unité de contrôle relativement sophistiquée comme, par exemple, un microcontrôleur, des sondes de courant détectant le sens du courant dans les bobinages de l'induit de l'alternateur, un pont image, etc. L'un de ces ponts redresseurs est décrit dans la demande de brevet FR-A-2 806 553. Ce pont redresseur est représenté sur la figure 1. Il comporte trois branches B1, B2, B3 de au moins deux transistors chacune, connectées chacune entre une phase de l'alterno-démarreur ϕ1, ϕ2, ϕ3, l'alimentation Ua du réseau de bord et la masse GND. Chaque transistor T1 à T6 est piloté par une unité de commande U1 à U6. Ces unités de commande U1 à U6 forment ensemble l'unité de contrôle de l'unité de puissance formée par le pont d'interrupteurs. Chacune de ces unités de commande est prévue pour comparer une tension de phase de l'alternateur avec une tension de référence et pour commander un des transistors du pont redresseur, en fonction du résultat de la comparaison. Chacune de ces unités de commande comporte des moyens distincts de ceux des autres unités et prévus pour réaliser, de manière distincte des autres unités, une comparaison et une compensation des variations de sa tension de référence, de sorte que chaque unité ne nécessite aucun signal que ceux ayant même variation que la tension de phase et que ceux ayant même variation que sa tension de référence. Chaque unité de commande U1 à U6 commande un transistor de puissance T1 à T6.

Cette unité de contrôle, comme la plupart des unités de contrôle connues actuellement, nécessite un nombre de composants électroniques important puisqu'il nécessite une unité de commande par transistor du pont redresseur.

Les composants utilisés pour réaliser l'unité de puissance sont donc placés et connectés sur une première carte électronique et forment l'étage de puissance.

Les composants utilisés pour réaliser l'unité de contrôle sont placés et connectés sur une seconde carte électronique.

Les deux cartes électroniques, formant le module de contrôle et de puissance, sont connectées ensemble par des fils électriques. Or, la liaison électrique de ces deux cartes nécessite un grand nombre de connexions entre les deux étages. En conséquence, le module de contrôle et de puissance est relativement encombrant, ce qui nécessite de le placer dans un boîtier distinct du boîtier contenant l'ensemble électromécanique de l'alterno-démarreur.

Ainsi, contrairement aux alternateurs classiques qui sont entièrement intégrés dans un même boîtier, l'alterno-démarreur nécessite deux boîtiers, à savoir un boîtier comportant l'alterno-démarreur lui même et un boîtier contenant le module de contrôle et de puissance. Un alternateur-démarreur nécessite donc un encombrement supérieur à un alternateur classique. De plus, il entraîne, pour l'utilisateur, une difficulté de mise en place supplémentaire, dans le véhicule automobile, car c'est au constructeur automobile de connecter les deux boîtiers ensemble.

Par ailleurs, il est connu par EP1134886, EP0357183 et EP0660501 des dispositifs applicables dans le domaine technique de l'invention.

Le document EP1134886 décrit un dispositif de redressement de tension pour un alternateur de véhicule automobile. Ce dispositif comporte un pont de commutation équipé de modules qui comparent une tension de phase de l'alternateur à une tension de référence et commandent un des commutateurs en fonction du résultat de la comparaison. Le dispositif de redressement de tension comporte des comparateurs et des amplificateurs pour compenser les effets des variations d'une tension de référence. Chaque module comprend des compensateurs de tension qui sont différents pour chaque module.

Le document EP0357183 décrit un dispositif et un procédé de commande faisant appel à une machine électrique tournante couplée au moteur thermique d'un véhicule pour remplir des fonctions de démarrage moteur et de générateur électrique. Une unité de commande électronique prend en compte la tension batterie et la vitesse de la machine électrique afin de maintenir constants des rapports tension/fréquence déterminés pendant les opérations de démarrage et de génération électrique. Trois circuits d'attaque dits « drivers » sont prévus pour commander respectivement les trois branches d'un pont de commutation.

Le document EP0660501 traite d'un alterno-démarreur de véhicule. L'alterno-démarreur comporte un convertisseur comprenant plusieurs transistors de puissance MOSFET. Le convertisseur est connecté entre les bobinages statoriques et une batterie d'accumulateurs du véhicule. Des circuits d'attaque dits « drivers » et un module de commande sont également prévus. Les transistors de puissance MOSFET, le convertisseur, les circuits d'attaque et le module de commande sont intégrés dans un seul module.

### Exposé de l'invention

L'invention a justement pour but de remédier aux inconvénients des techniques exposées précédemment. A cette fin, l'invention propose un module de contrôle et de puissance miniaturisé et pouvant être intégré dans le boîtier de l'alterno-démarreur.

Plus précisément, l'invention concerne un module de contrôle et de puissance d'un alternateur-démarreur pour véhicule automobile tel que défini par la revendication 1.

### Brève description des figures

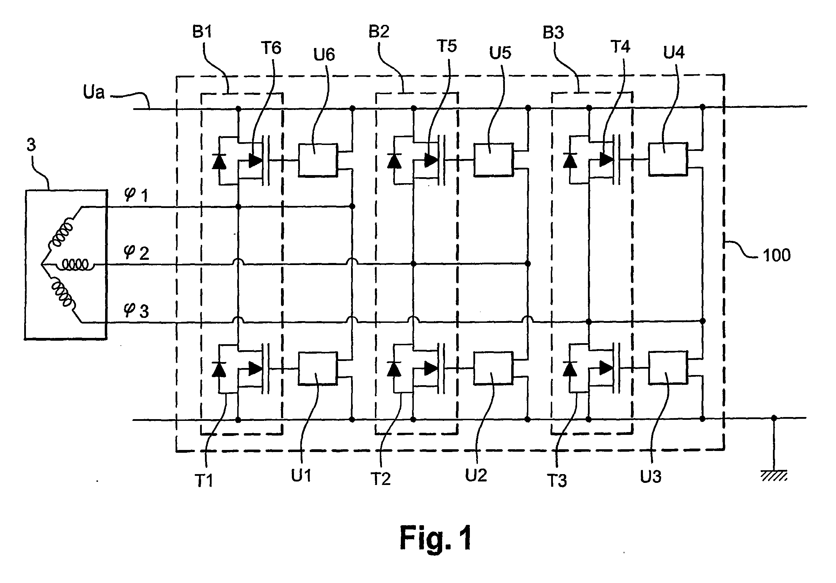

La figure 1, déjà décrite, est une représentation schématique d'un module de contrôle et de puissance selon l'art antérieur.
La figure 2 représente un module de contrôle et de puissance selon l'invention.
La figure 3 représente les différentes connexions d'un driver dans une unité de contrôle de l'invention.
La figure 4 représente les connexions électriques entre un driver et les transistors de l'unité de puissance qu'il pilote.
La figure 5 représente un mode d'intégration du module de contrôle et de puissance de l'invention, à l'arrière d'un boîtier d'altemateur-démarreur.
La figure 6 représente une vue en en élévation d'un mode de réalisation d'un module de puissance selon l'invention.
La figure 7 est une vue en coupe selon la ligne A-A de la figure 6.
La figure 8 est une vue en coupe de la réalisation d'un module de puissance selon un autre mode de réalisation.
Les figures 9 à 11 représentent un mode de connexion à la masse des modes de réalisation correspondant aux figures 6 à 8.
La figure 12 et un autre mode de réalisation de l'invention.
La figure 13 est une vue en coupe d'un palier arrière comportant les modules électronique de puissance selon l'invention.
La figure 14 montre un exemple de ventilateur utilisé dans la figure 13.
Les figures 15, 16, 17 et 17a montrent des mode de connexion des sorties des modules électronique réalisées au niveau du capot.
Les figures 18 et 19 montrent une vue axiale arrière du capot de la machine électrique.
La figure 20 montre un alternateur-démarreur selon l'art antérieur.
Les figures 21 et 22 montrent un exemple de réalisation des modules représentés aux figures 7 et 12.
La figure 23 est une vue en coupe de la figure 12.

### Description détaillée de modes de réalisation de l'invention.

Dans les figures les éléments identiques ou similaires seront représentés par les mêmes signes de référence. La tension de bord référencée Ua peut également être appelée B+.

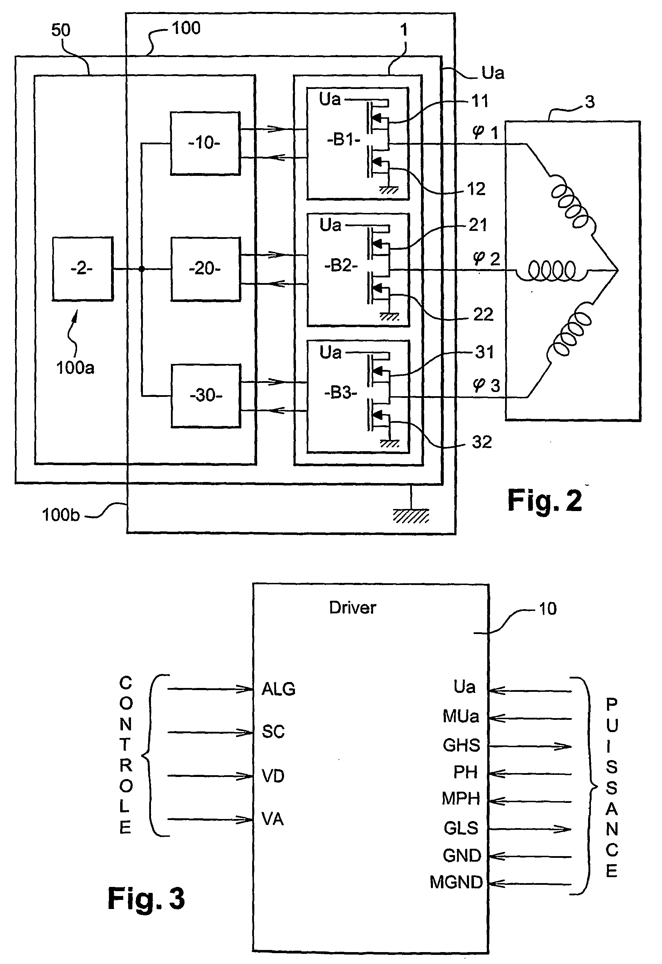

La figure 2 représente le module de contrôle et de puissance 100 de l'invention, connecté à l'alterno-démarreur. Plus précisément, cette figure 2 montre un alterno-démarreur 3 triphasé dont chaque phase ϕ1, ϕ2 et ϕ3 est connectée à une des branches, respectivement B1, B2 et B3, de l'unité de puissance 1. Chacune des 3 branches du pont redresseur ou de commande constituant l'unité de puissance 1 sont identiques. En conséquence, seule la branche B1 sera décrite en détail par la suite.

La branche B1 du pont redresseur 1 comporte deux interrupteurs 11 et 12, qui, dans l'invention, sont des transistors de puissance. Le transistor 11 est le transistor « high side » de la branche B1. Il est connecté entre la phase ϕ1 de l'alterno-démarreur et l'alimentation Ua du réseau de bord du véhicule. Le transistor 12 est le transistor « low side » de la branche B1. Il est connecté entre la phase ϕ1 de l'alterno-démarreur et la ligne de masse GND.

Le module de contrôle et de puissance comporte une unité de contrôle 50 comprenant d'une part, les drivers 10, 20, 30 pilotant chacun les transistors de puissance d'une même branche et, avantageusement, ces drivers comparent les potentiels de phase ϕ1, ϕ2 , ϕ3 de l'alterno-démarreur avec le potentiel de masse du pont redresseur pour la commande du transistor 12 et avec le potentiel de sortie Ua du pont redresseur pour la commande du transistor 11, et d'autre part, un circuit de gestion 2 des drivers 10, 20 et 30.

Les branches du pont redresseur ainsi que les drivers qui les pilotent forment un premier étage 100b du module de l'invention. Le circuit de gestion 2 forme un second étage 100a.

Le driver 10 est connecté, en sortie, aux grilles des deux transistors 11 et 12. Ce driver 10 est lui même connecté, par son entrée, au circuit de gestion 2.

Chaque driver 10, 20 et 30 est contrôlé par le même circuit de gestion 2. Pour cela chaque driver reçoit en entrée différents signaux provenant du circuit de gestion 2. Ces signaux sont représentés sur la figure 3.

Ces signaux sont répartis en deux catégories :
- les signaux indiqués à gauche du driver : ce sont les signaux provenant du circuit de gestion ; et
- les signaux indiqués à droite du driver : ce sont les signaux reçus ou transmis à l'unité de puissance, c'est-à-dire aux transistors que pilote le driver.

L'un des signaux reçus du circuit de gestion est l'alimentation boost, nommée ALG, qui est la tension d'alimentation fournie par une source auxiliaire aux grilles des transistors 11 et 12. Le driver reçoit également, du circuit de gestion, des signaux de capteur SC qui sont des informations fournies par les capteurs de position du rotor de l'alterno-démarreur pour indiquer position du rotor de la machine électrique tournante. Le circuit de contrôle fournit également au driver une information VD de validation du mode démarreur et une information VA de validation du mode alternateur. Ces deux derniers signaux permettent au driver de savoir si l'alterno-démarreur doit travailler, à un instant précis, comme un alternateur ou comme un démarreur.

Sur cette figure 3, on a représenté également les signaux reçus et transmis à l'unité de puissance, c'est-à-dire aux transistors 11 et 12 du pont redresseur. Le driver reçoit le potentiel d'alimentation Ua de l'alterno-démarreur, à savoir le potentiel de l'alimentation du réseau de bord. Il reçoit également une information MUa qui est l'entrée de mesure du potentiel de cette ligne Ua. Le driver fournit en sortie un signal GHS qui est le signal de commande de la grille du transistor de puissance 11. Le driver reçoit aussi l'entrée de phase PH provenant de l'alterno-démarreur ainsi que la mesure MPH du potentiel de l'entrée de phase. Le driver fournit aussi en sortie la commande GLS de la grille du transistor de puissance 12. Enfin, le driver reçoit le potentiel de la masse GND ainsi que la mesure MGND du potentiel de la masse.

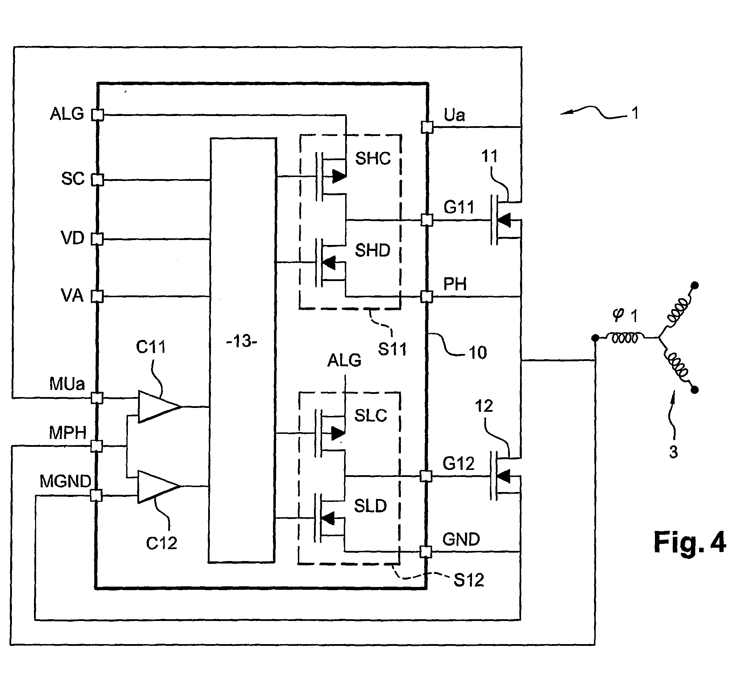

Sur la figure 4, on a représenté un driver 10, 20, 30 du module de contrôle et de puissance 100 de l'invention, avec ses différents composants et ses différentes connexions. Sur cette figure 4, l'alterno-démarreur 3 fournit un signal de phase ϕ1 aux transistors low side 12 et high side 11 ainsi qu'à l'entrée PH du driver. Il fournit aussi la mesure de phase au driver 10 sur son entrée MPH.

Sur cette figure 4, les entrées des mesures MPH MGND et MUA ont été représentées à gauche du driver pour une simple question de simplification de la figure. En pratique, comme montré sur la figure 3, ces trois entrées sont placées sur le côté droit du driver, c'est-à-dire sur le côté de l'unité de puissance.

Le transistor 12 est connecté à la masse GND ainsi qu'à l'entrée MGND du driver. Le transistor 11 est connecté à la ligne de tension Ua ainsi qu'à à l'entrée MUa du driver.

Deux comparateur C11 et C12 sont connectés, respectivement, entre les entrées MUa et MPH et entre les entrées MPH MGND du driver. Le signal de sortie du comparateur C11 fournit une valeur de comparaison entre la valeur de la phase MPH et la valeur de la tension de référence MUa. Le signal de sortie du comparateur C12 fournit une valeur de comparaison entre la valeur de la phase MPH et la valeur de la masse MGND. Ces valeurs de comparaison sont ensuite traitées numériquement par un circuit logique 13 pour en déduire si c'est la grille du transistor 11 et/ou la grille du transistor 12 doivent être chargées et/ou déchargées. Les grilles G11 et G12 des transistors de puissance respectifs 11 et 12 sont chargés et déchargés par des sources de courant, respectivement, S11 et S12. Les sources de courant S11 sont réalisées, par exemple, à partir de deux transistors SHC et SHD. Les sources de courant S12 sont réalisées, par exemple, à partir de deux transistors SLC et SLD. Ainsi, chaque transistor constitue une source de courant.

L'entrée ALG est un potentiel élevé, délivré par le circuit de gestion 2 pour charger correctement la grille des transistors de puissance 11 et 12, par l'intermédiaire des sources de courant S11 et S12. Ce potentiel ALG peut être, par exemple : ALG = Ua + 16 volts

Le fonctionnement du driver de la figure 4 est le suivant : en mode démarreur, des capteurs de position, placés sur le rotor de l'alterno-démarreur qui travaille en machine synchrone, repère la position du rotor. Les signaux capteurs sont transmis au circuit de gestion 2 qui les traite et les applique aux entrées SC des drivers. Les grilles G11 et G12 des transistors 11 et 12 sont commandées en fonction des signaux reçus sur l'entrée SC, par l'intermédiaire du circuit logique 13 et des sources de courant S11 et S12.

En mode alternateur, les transistors de puissance 11 et 12 fonctionnent en redressement synchrone, c'est-à-dire que les comparateurs C11 et C12 détectent le niveau de phase sur l'entrée MPH, par rapport au potentiel de masse sur l'entrée MGND et au potentiel de sortie sur l'entrée MUa. Le résultat de cette comparaison est appliqué aux grilles G11 et G12 par l'intermédiaire du circuit logique 13 et des sources de courants S11 et S12.

Le mode alternateur ou démarreur est sélectionné sur le driver par les entrées logiques respectives VA et VD. Par exemple, lorsque le mode alternateur est sélectionné, l'entrée VA reçoit un signal logique à 1 et l'entrée VD un signal à 0. Et inversement lorsque le mode démarreur est sélectionné. Le niveau logique 1 est, par exemple, une tension de 5 volts et le niveau logique 0 une tension nulle.

Les entrées de mesures de la phase MPH, du potentiel MUa et de la masse MGND permettent d'éviter les effets des perturbations crées par les courants qui circulent dans les connexions PH, Ua et GND. Ces perturbations peuvent être provoquées, par exemple, par la résistance des connexions entre composants entre eux ou sur le substrat de la carte électronique.

Chaque driver étant situé à proximité des potentiels PH, VA, GND à mesurer, les entrées de mesure MPH, MVA, MGND utilisent des connexions de longueur réduite, ce qui diminue d'autant la sensibilité de ces entrées par rapport aux perturbations pouvant transiter par ces connexions ce qui justifie davantage l'architecture proposée selon l'invention.

Par contre, le circuit de gestion 2 peut être éloigné des drivers car il ne transmet que des potentiels peu critiques (alimentation ALG, niveaux logiques VA, VD, SC) contrairement aux entrées de mesure (MPH, MVA, MGND).

Les grilles des transistors 11 et 12 doivent pouvoir être portées à des potentiels supérieurs au potentiel Ua de sortie de l'alternateur-démarreur. Dans ce but, le circuit de contrôle délivre sur la borne ALG une tension Ua + 16 volts, +/- 1 qui permet d'alimenter les grilles G11 et G12 des transistors 11 et 12. Si la tension sur la borne ALG n'est pas suffisante, alors les transistors de puissance 11 et 12 sont ouverts.

Le fonctionnement du module de contrôle et de puissance 100 de l'invention va maintenant être décrit. En mode repos, c'est-à-dire lorsque le véhicule est à l'arrêt et que la clé de contact est ouverte (c'est-à-dire non tournée dans la serrure du commutateur d'allumage), alors le transistor 11 est ouvert tandis que le transistor 12 est fermé. Cette condition est obtenue lorsque les entrées logiques VD et VA sont toutes deux au niveau 0. Lorsque le moteur du véhicule est arrêté et que la clé de contact est ouverte, le circuit de gestion 2 est inactif et ne peut délivrer la tension Ua + 16 volts sur l'entrée ALG du driver. En conséquence, on applique sur la grille G12 du transistor 12 une tension dont la valeur minimale est Ua - 1 volts.

En d'autres termes, lorsque la clé est ouverte et que VD et VA sont à 0 alors la tension de grille du transistor 11 est inférieure ou égale à 0,2 volts et la tension de grille du transistor 12 est supérieure à Ua - 1 volts. En d'autres termes, le transistor 12 est fermé tandis que le transistor 11 est ouvert, ce qui maintien le potentiel du stator au potentiel de masse.

Le courant consommé par le driver, dans ces conditions, est inférieur à 10 micro-ampères, à 25° C.

Lorsque le véhicule est à l'arrêt et que l'on tourne la clé de contact dans la serrure du commutateur d'allumage (c'est-à-dire la clé de contact est fermée) alors cela entraîne la mise en route du circuit de contrôle 2. Ce circuit de gestion 2 est alors actif et peut délivrer la tension Ua + 16 volts sur l'entrée ALG du driver. Dans ces conditions, le potentiel de grille G11 du transistor 12 est limité à 15 +/- 1 volts. Autrement dit, lorsque la clé est fermée et que VD et VA sont à 0, alors la tension de grille du transistor 11 reste inférieure ou égale à 0,2 volts et la tension de grille du transistor 12 est égale à 15 +/- 1 volts.

En mode démarreur, les entrées de validation VD et VA ne sont plus toutes deux à 0. Le mode démarreur fait intervenir aussi l'entrée du signal capteur SC. Ainsi, en mode démarreur, le pont redresseur fonctionne comme un onduleur. Chaque branche du pont redresseur est synchronisée avec le signal capteur SC, appliqué au driver correspondant. Le mode de fonctionnement en onduleur est obtenu quand VD est à 1 et que l'entrée VA est à 0.

Ainsi, si SC = 0 et VA = 0 et VD = 1, alors la tension de grille G11 du transistor 11 est inférieure à 0,2 volts et la tension de grille G12 du transistor 12 est égale à 15 +/- 1 volts. Au contraire, si SC = 1 et VA = 0 et VD = 1, alors la tension de grille G11 du transistor 11 est égal à 15 +/- 1 volt et la tension de grille G12 du transistor 12 est inférieure à 0,2 volts. Le circuit de contrôle et de puissance 100 fonctionne alors en onduleur, les tensions appliquées que les phases Ph1, Ph2 et Ph3 étant liées à la position du rotor en fonction des signaux SC1, SC2 et SC3 délivrés par les capteurs de position après traitement par le circuit de gestion 2.

En mode alternateur, le pont redresseur fonctionne en redressement synchrone. Cette fonction est activée quand l'entrée de validation VA est à 1 tandis que l'entrée VD est à 0. Dans ce cas, les comparateurs C11 et C12 du driver comparent, d'une part, la tension de phase PH à la tension Ua et, d'autre part, la tension de phase PH au potentiel de masse GND. Le résultat de la comparaison permet d'ouvrir et/ou de fermer les transistors 11 et 12 en synchronisme avec les courants circulants dans les bobinages induits de l'alternateur-démarreur. L'effet sur les grilles des transistors 11 et 12 est le suivants :
- Si PH > Ua et VD = 0 et VA = 1 alors la tension de grille G11 du transistor 11 est égale à 15 +/- 1 volts et la tension de grille G12 du transistor 12 est inférieure à 0,2 volts, et en conséquence : le transistor 11 est fermé et le transistor 12 ouvert.
- Si Ua > PH > GND et VD = 0 et VA = 1 alors la tension de grille G11 du transistor 11 est inférieure à 0,2 volts et la tension de grille G12 du transistor 12 est aussi inférieure à 0,2 volts, et en conséquence : les transistor 11 et 12 sont fermés.
- Si GND > PH et VD = 0 et VA = 1 alors la tension de grille G11 du transistor 11 est inférieure à 0,2 volts et la tension de grille G12 du transistor 12 est égale à 15 +/- 1 volts et en conséquence : le transistor 12 est fermé et le transistor 11 ouvert.

En mode de redressement classique, le circuit de contrôle 2 peut commander l'ouverture de tous les transistors de puissance 11, 12, 21, 22, 31 et 32 du pont redresseur pour supprimer le redressement synchrone. Ce mode de fonctionnement est obtenu quand les deux entrées de validation VD et VA sont au niveau logique 1. Le redressement s'effectue alors par les diodes propres à la technologie des transistors MOS.

Dans ce cas, quand VD = 1 et VA = 1 alors la tension de grille G11 du transistor 11 et la tension de grille G12 du transistor 12 sont inférieures chacune à 0,2 volts.

Les tensions de grille des transistors de puissance 11 et 12 sont contrôlées par des sources de courant constant, non représentées sur la figure par mesure de simplification. Le contrôle de la fermeture est réalisé par un courant de charge de grille de 100 milliampères, par exemple, et le contrôle de l'ouverture par un courant de décharge de grille de 400 milliampères, par exemple.

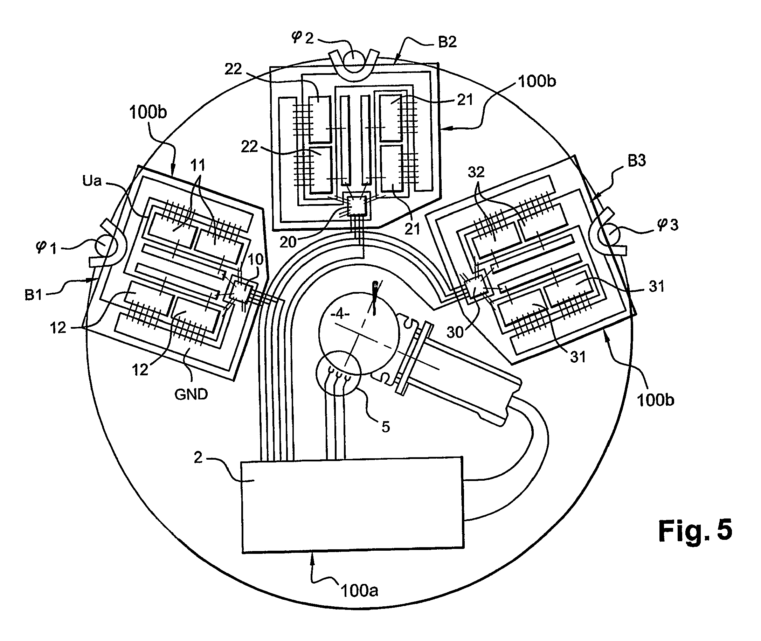

Sur la figure 5, on a représenté un exemple d'intégration du module de contrôle et de puissance de l'invention, à l'arrière d'un alterno-démarreur. En effet, le fait d'utiliser un seul driver pour commander les deux transistors d'une même branche du pont redresseur permet de diminuer le nombre de connexions vers l'unité de gestion 2.

En particulier, le driver est réalisé de façon à ce que, d'un coté, il comporte uniquement des connexions allant vers l'unité de puissance et, de l'autre coté, uniquement des connexions allant vers le circuit de gestion 2. De cette façon, le driver peut être facilement connecté à proximité des transistors de puissance qu'il pilote. En outre, dans cet exemple de réalisation, seule quatre connexions sont nécessaires entre un driver et le circuit de gestion 2, trois de ces quatre connexions étant de plus communes à tous les drivers. Il est donc aisé de séparer le circuit de gestion 2 des drivers. La taille du circuit de gestion 2 résultant de cette séparation se trouve ainsi très nettement réduite. Le circuit de gestion 2 peut donc être intégré dans un autre équipement du véhicule.

Dans l'exemple de la figure 5, le module de contrôle et de puissance 100 est intégré à l'arrière de l'alterno-démarreur. Sur la figure 5, on voit la face arrière d'un alterno-démarreur avec ses sorties de phases et son rotor. Dans le cas de cette figure 5, chaque driver est positionné au voisinage des transistors de puissance qu'il commande, l'ensemble étant situé à proximité d'une des sorties de phase de l'alterno-démarreur. Par exemple, le driver 10 est connecté juste à coté des transistors 11 et 12 de la branche B1 du pont redresseur, l'ensemble transistors et driver étant placé à proximité de la sortie de phase ϕ1 de l'alterno-démarreur. De même, le driver 20 et les transistors 21 et 22 de la branche B2 du pont redresseur sont placés à côté de la sortie de phase ϕ2 et le driver 30 et les transistors de la branche B3 sont placés à coté de la sortie de ϕ3 de l'alterno-démarreur.

Dans l'exemple de la figure 5, chaque branche du pont redresseur comporte plusieurs transistors high side et plusieurs transistors low side. En effet, comme c'est classiquement le cas, plusieurs transistors (souvent 2 à 4) sont connectés en parallèle de façon à former un transistor de puissance plus important. Qu'il y ait un seul transistor de puissance ou plusieurs transistors connectés en parallèle, le fonctionnement est identique à celui qui vient d'être décrit.

L'extrémité de l'arbre 4 (schématisé par un rond sur la figure 5) qui porte le rotor de la machine électrique tournante comporte des capteurs de position 5 qui fournissent des indications sur la position du rotor au circuit de gestion 2. Ces informations de position du rotor sont traitées par le circuit de gestion 2 puis transmises aux entrées SC des drivers 10, 20 et 30.

Avantageusement, les connexions réalisées entre l'unité de gestion 2 et les différents drivers forment un arc de cercle positionné autour de l'arbre 4 portant le rotor.

Dans le cas de la figure 5, le module de contrôle et de puissance 100 est intégré dans le boîtier de l'alterno-démarreur. Cet ensemble peut aussi être intégré dans un autre équipement du véhicule, comme dans le boîtier de gestion de charge de la batterie.

Il est aussi possible d'intégrer uniquement l'unité de puissance avec ses drivers 10, 20 ,30 respectifs et de placer le circuit de gestion 2 dans un boîtier extérieur à l'alterno-démarreur. Par exemple, le circuit de gestion 2 peut être intégré dans le boîtier de la batterie ou bien dans le boîtier de gestion de la batterie ou encore dans le boîtier de gestion des consommateurs (body contrôler).

Dans un autre mode de réalisation, le module de contrôle et de puissance 100 est intégré dans un boîtier indépendant, extérieur à l'alterno-démarreur mais plus compact que dans l'art antérieur.

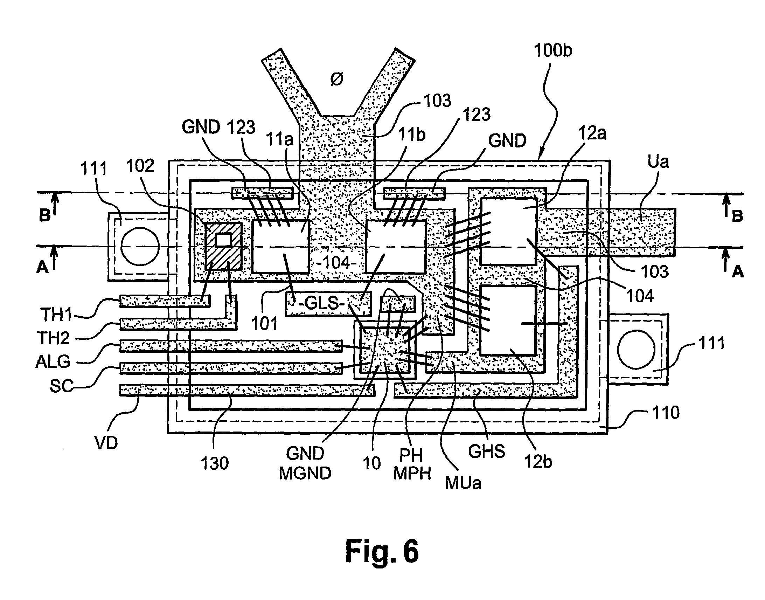

La figure 6 illustre un exemple de réalisation du premier étage 100b d'un module de contrôle et de puissance 100 selon l'invention. Comme décrit précédemment, ce premier étage comporte pour chacun des bras de redressement, correspondant chacun à une phase du stator, un driver 10 de mesure et de commande ainsi que les deux transistors de puissance. Ainsi, si on considère un premier bras de pont de redressement ou de commande nous avons le driver 10 ainsi que les deux transistors de puissance 11 et 12 précédemment décrits.

Selon l'invention, ce premier étage de contrôle et de puissance est avantageusement réalisé dans un boîtier indépendant. Les trois bras de pont étant identiques, il est ainsi possible d'utiliser un boîtier de puissance identique pour chacun des bras de pont.

Comme visible sur la figure 6, qui montre un premier étage de module de contrôle et de puissance selon une vue en élévation, les composants électroniques de puissance 11 et 12 sont placés sur des traces métalliques 104.

Avantageusement, la technologie utilisée est la technologie dite de report de puce ou puce nue dans laquelle le composant, dépourvu de boîtier de protection est directement fixé sur un support. En effet, ce boîtier électronique, placé sous le capot moteur du véhicule automobile est soumis à de fortes contraintes thermique et il faut éviter d'utiliser des composants sous boîtier plastique. Avantageusement, il est donc préférable d'utiliser des composants sous boîtier métallique ou des composants montés selon la technologie dite de report de puce dans laquelle le composant est reporté sur une trace métallique. Le réseau obtenu par l'ensemble des traces métalliques constitue ce qu'on appelle le lead-frame.

Pour commander les phases du bobinage de la machine électrique en mode démarreur, il est nécessaire d'injecter de très forts courants. Ces courant peuvent atteindre une valeur d'environ 1000 Ampère lorsque le dispositif fonctionne sous une tension de réseau de bord traditionnelle d'environ 12 Volts. Ainsi, les transistor low-side et high-side 11 et 12 peuvent être constitués par la mise en parallèle d'au moins deux transistors de puissance respectivement 11a, 11b et 12a, 12b.

Avantageusement le module de puissance 100b comporte une thermistance 102 (capteur de température) accessible par les liaisons TH1, TH2.

Le driver 10 est soumis a des températures nettement inférieures à celle présentes au niveau des transistors de puissance. Il en est de même pour les traces constituants les signaux de commande ou de mesure ALG, SC, VD, GLS, GHS, TH ... aux fonctionnalités précédement décrites.

La commande d'un alternateur-démarreur faisant intervenir de très forts courants, de très nombreux problèmes de conception se posent à l'homme du métier pour réaliser une commande de faible encombrement et apte à répartir les courants et la température de manière équilibrée au sein du module.

Ainsi, selon l'invention, chaque module, correspondant à un bras de pont, est lié à chacune des phases et fonctionne de manière indépendante sans être traversé par les courants provenant des autres modules. Ainsi la trace portant la sortie Ua est reliée à un seul endroit à un conducteur de puissance qui rassemble les courants provenant de tous les modules. Chacun des modules travaille donc de manière indépendante, sans être traversé ou perturbé par les courants relatifs aux autres modules. D'autre part, les transistors de puissance 11a et 12a sont avantageusement assemblés de manière parfaitement symétrique sur la trace métallique par rapport à l'entrée de phase ϕ1. Nous obtenons ainsi une répartition de courant parfaitement équilibrée. De même pour les transistors de puissance high-side 12a et 12b, ceux-ci sont montés sur leur trace métallique de manière la plus symétrique possible pour les mêmes raisons. Cela est très important pour ne pas déséquilibrer les courants dans les transistors de puissance qui doivent travailler en parallèle avec des courants identiques. Ainsi, pour obtenir un module de puissance bien équilibré en courant selon l'invention et comme représenté sur la figure 6, les transistors de puissance low-side et high-side sont montés de manières sensiblement perpendiculaire les uns par rapport aux autres. Cette configuration présente en outre l'avantage de réaliser toutes les connexions par wire-bonding sans faire aucun recouvrement au dessus de traces de signal ou de puissance quelconque. Ainsi, toutes les connexions sont réalisées avec des conducteurs 101 de courte longueur ce qui présente l'avantages d'obtenir un module fiable résistant notamment aux vibrations. En effet, l'environnement automobile est très vibratoires, et les fils de connexions par bonding sont soumis à de fortes vibrations qui peuvent les rompre et contribuer au disfonctionnemnet du système alternateur-démarreur. La réduction au maximum de la longueur de ces fils de connexion augmente leur fréquence de résonnance ce qui les rend insensibles aux vibrations appliquées aux module de puissance.

Comme indiqué précédement, un but de l'invention est de réaliser une commande pour alternateur-démarreur compacte avec un grand pouvoir de refroidissement tout en présentant une grande fiabilité de fonctionnement dans le temps.

Pour réaliser un tel module de puissance apte à faire circuler des courants pouvant monter à environ 1000 ampères, l'état de la technique propose certaines solutions.

Le module de puissance pourrait être réalisé selon la technologie connue à substrat de type DBC (pour « Direct Bounded Copper »), qui comporte trois couches. Une première couche est constituée d'une trace métallique gravée formant les liaisons d'un circuit électrique, une deuxième couche intermédiaire est une plaque de matériau isolant électriquement tel qu'une céramique, par exemple de l'oxyde d'alumine, et une troisième couche est une plaque métallique constituée de cuivre ou de cuivre nickelé. On obtient ainsi une structure sandwich cuivre-alumine-cuivre.

L'ensemble constitué du substrat de type DBC et des composants électroniques de puissance brasés ou collés est à son tour brasé sur une plaque de cuivre, formant support mécanique et dissipateur thermique. Dans cette technologie, les traces de cuivres présentent une faible épaisseur en sorte que pour faire passer de forts courant, il est nécessaire d'augmenter considérablement la surface des traces ce qui augmente très fortement l'encombrement du module de puissance. De plus, cette technologie n'est pas applicable aux applications faisant appel à de forts courants car la capacité thermique offerte par la faible épaisseur du cuivre n'est pas suffisante. D'autre part, il est très difficile de réaliser des formes particulières, telle que des formes arrondies qui sont plus particulièrement adaptées pour s'intégrer sur des applications telles que par exemple l'arrière d'une machine électrique tournante du fait de la fragilité de l'alumine. D'autre part, l'alumine est peu résistante aux vibrations, telles que celles présentent à l'intérieur d'un bloc moteur de véhicule automobile.

Le substrat peut également être de type SMI (Substrat Métallique Isolé). Dans ce cas, la plaque de céramique est remplacée par une plaque de résine, pouvant supporter une première couche constituée d'une trace métallique de cuivre très fine. La troisième couche de dissipation thermique peut dans ce cas être constituée d'une plaque métallique en aluminium ou en cuivre.

Dans le cas où le substrat utilisé est un substrat de type DBC, le module de puissance est robuste et supporte une forte puissance mais a un prix de revient élevé. Dans le cas d'un substrat de type SMI, la trace métallique découpée peut être plus complexe et on peut disposer un plus grand nombre de composants électroniques de puissance sur celui-ci, mais le module est moins résistant aux fortes puissances et aux contraintes d'environnement sévères. Toutefois, il est possible dans la technologie SMI de rajouter une interface supplémentaire en cuivre, interposée entre la puce et la trace métallique de cuivre fine pour permettre une meilleure évacuation de la chaleur. Cette solution, complexe à réaliser, est peu satisfaisante d'un point de vue économique

Dans les deux cas, le chemin thermique entre les composants électroniques de puissance et des moyens de refroidissement extérieurs au module de puissance est long puisqu'il nécessite de traverser au moins les nombreuses couches du substrat que comportent ces deux technologies.

L'invention vise à remédier aux inconvénients des modules de puissance classiques, en fournissant un module de puissance dont la fabrication est peu chère, et dont la structure permet un refroidissement efficace à l'aide de moyens de refroidissement extérieurs et par le faible nombre d'interfaces thermiques à traverser.

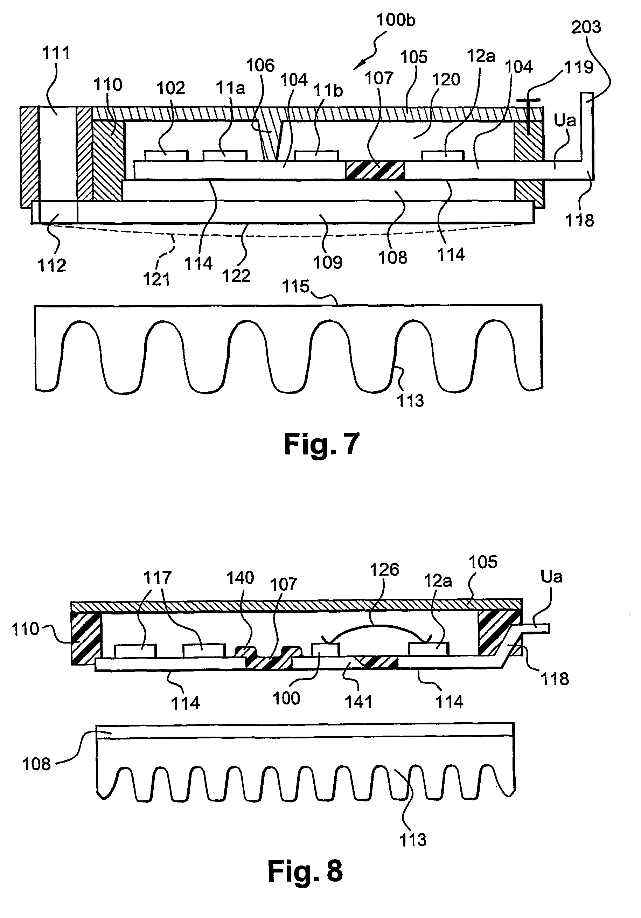

Ainsi comme représenté à la figure 7 le module de puissance comporte des traces métalliques de puissance 104 destinées à recevoir par exemple les composants de puissance 11 a et 11 b réliés à la sortie de phase du bobinage du stator de la machine électrique. Cette même trace métallique peut également porter une thermistance 102 pour apprécier la température du module. Ce module de puissance, comme décrit précédement peut comporter d'autres traces métalliques de puissance 104. Ainsi comme représenté sur la figure 7, une autre trace métallique de puissance porte le composant de puissance 12 relié à la sortie +Ua dans notre exemple de réalisation.

Avantageusement, ces traces métalliques sont réalisées à partir d'une même plaque métallique conductrice dans laquelle les traces métalliques sont par exemple réalisées par estampage. Avantageusement, et pour obtenir un module compact selon l'invention, les traces métalliques réalisée à partir de la plaque métallique, de préférence en cuivre, est de forte épaisseur pour le passage des forts courants. Ainsi l'épaisseur de ces traces peut varier entre 0.6 mm et 2mm. Les techniques usuelles précitées ne permettent pas d'obtenir des traces d'une telle épaisseur au sein du substrat lui-même. En effet les épaisseurs usuellement utilisées pour la réalisation de traces ne dépasse guère les 400µm d'épaisseur. Pour des raisons évidentes, il n'est pas envisageable de réaliser des traces d'une telle épaisseur par des opérations de gravure classiques.

Pour assurer un bon positionnement des traces les unes par rapport aux autres, des ponts métalliques sont réalisés lors de l'opération d'estampage. Bien évidement, ces ponts métalliques seront supprimés lors d'une opération de deshuntage qui sera réalisée en fin de procédé.

Avantageusement pour simplifier la réalisation de ce module de puissance, les traces métalliques de faible puissance destinées par exemple aux signaux de commande peuvent également être réalisées à partir de cette plaque métallique de forte épaisseur, leurs positionnement étant également réalisé par des ponts métalliques. L'ensemble de ces traces métalliques constitue le lead-frame.

Afin d'obtenir un lead-frame présentant une bonne cohésion mécanique, il est nécessaire de l'agencer avec un dispositif pour former un support. De plus, ce support doit être apte à évacuer efficacement la chaleur émise par le passage des forts courants. Ainsi selon l'invention, il est proposé d'injecter une résine 107 dans les espaces laissés libres entre les traces métalliques. Cette opération peut être facilement réalisée en plaçant le lead-frame entre deux plaques constituant le moule pour l'injection. Ainsi, à l'issue de l'opération d'injection de la résine tous les interstices entre les traces sont occupés par de la résine. L'opération de deshuntage peut être réalisée à l'issue de cette opération.

Avantageusement cette résine sera de type thermoplastique telle que du PPS (polysulfure de phénylène) ou du PA 6.6 (polyamide 6.6) ou du PBT (polybutylène téréphtalate). Le PPS présente en outre l'avantage d'être ininflammable (norme UL94V0).

Pour augmenter la cohésion mécanique du support formé par le lead-frame et la résine, les moules peuvent comporter des évidements afin que la résine recouvre localement les traces métalliques sur une faible portion 140 comme visible à la figure 8. Dans le même esprit, le bord des traces métalliques peut présenter des formes particulières, telle qu'un biseau 141 pour assurer un meilleur ancrage de la résine.

Après l'opération de deshuntage, les composants, dont notamment les composants de puissance, peuvent être solidarisés sur les traces métalliques par exemple par brasage selon un procédé de chauffage par laser ou par four (convection ou infrarouge). Cette brasure permet un contact électrique et thermique entre le composant et la trace métallique.

Ainsi selon l'invention, et comme illustré à la figure 8, on obtient un module électronique de puissance dans lequel les traces métalliques, portant notamment les composants de puissance 117, sont accessibles depuis l'extérieur par les faces opposées 114 à celles portant lesdits composants.

Le support du module de puissance selon l'invention est réalisé en sorte qu'au moins les traces métalliques de puissance sont en partie accessibles sur leurs faces supérieures et inférieures, la face supérieure étant destinée à recevoir le composant électronique de puissance et la face inférieure 114 destinée à coopérer avec un dispositif de refroidissement tel que le dissipateur 113 illustré à la figure 7. Avantageusement, les parties des faces inférieures des traces métalliques accessibles sont au droit des composants de puissances qu'elles portent sur leurs faces opposées supérieures pour obtenir un bon refroidissement desdits composants de puisssance.

Afin d'assurer un bon contact thermique entre ces faces 114 et la face supérieure 115 du dissipateur 113, il est prévu de mettre un élément 108 avantageusement élastique thermoconducteur et électriquement non conducteur pour d'une part bien évacuer la chaleur, et d'autre part, pour isoler électriquement les traces métalliques entre elles. Un tel élément peut par exemple être un tissu de verre imprégné d'une résine époxy ou polyamide (TVI) ou une résine thermoplastique thermoconductrice à changement de phase. Un matériau thermoconducteur et isolant électrique présentant deux faces adhésives ou une colle thermoconductrice 108 comportant des billes de verre formant entretoises peuvent également convenir. La résine à changement de phase présente l'avantage de fluer sous l'action de la chaleur. Ainsi si le radiateur ou la face inférieure du module de puissance présente des défauts de planéité, alors cette résine à changement de phase est apte à colmater ces irrégularités. Avantageusement, les traces amenées à sortir du module pour communiquer avec l'extérieur présente avantageusement un coude 118 orienté vers le haut du module de manière à les éloigner de la surface supérieure 115 du dissipateur 113.

Un tel module, correspondant à chacun des bras de pont peut être amené à être fabriqué en très grande quantité. Dans ce cas, il devra présenter une très grande cohésion mécanique tout en conservant ses aptitudes d'évacuation de la chaleur. Ainsi, comme illustré à la figure 7, il est prévu de placer sous ce module de puissance une plaque métallique 109 formant embase au potentiel de masse. Cette embase est maintenue dans une ceinture isolante 110 réalisée avantageusement par surmoulage. Pour des raisons de tenue mécanique, cette ceinture est avantageusement réalisée avec du PPS. Un capot est fixé sur cette ceinture qui pour les mêmes raisons est également en PPS.

Ce capot est fixé par exemple au moyen de vis 119 qui pénètrent dans la ceinture 110. Dans d'autres modes de réalisations, ce capot peut être fixé par exemple par collage ou par des moyens de soudure telle que la soudure par ultrasons ou par friction.

A l'intérieur du module de puissance, sous le capot 105 du module de puissance, un matériau de remplissage 120 peut être déposé pour remplir les espaces libres autour des composants électroniques et entre les connexions filaires par exemple de type wire bonding. Ce matériau 120 de remplissage, outre sa fonction d'étanchéité, présente l'avantage de renforcer la cohésion mécanique du support formé par les traces métalliques et la résine qui les entoure.

Dans le mode de réalisation illustré à la figure 7 un isolant électrique et thermoconducteur est placé entre l'embase métallique 109 et la face inférieure 114 des traces métalliques. Comme décrit précédemment dans la figure 8 cet isolant 108 électrique thermoconducteur peut être du TVI ou une résine thermoplastique thermoconductrice à changement de phase. Avantageusement, cet isolant est collé sur ses deux faces, d'une part du coté des traces métalliques et d'autre part du coté de l'embase métallique 109. Ainsi, cette embase assure une protection efficace envers les traces métalliques et permet ainsi d'obtenir un module de bonne cohésion mécanique et de manipulation aisée.

Cette embase 109 est réalisée dans une matière thermoconductrice et fait partie de l'élément dissipateur en contact avec la face inférieure 114 des traces métalliques à refroidir.

Comme visible à la figure 7 un doigt 106, avantageusement issu de matière du capot de protection 105, vient en appui contre au moins une trace métallique. Dans le cas ou un matériau de remplissage 120 est introduit au dessus des composants électroniques, alors le matériaux de remplissage se place autour de ce doigt.

Ce doigt contribue d'une part à assurer une bonne cohésion mécanique de l'ensemble de ce module de puissance par formation d'un module rigide, et d'autre part, ce doigt, qui vient en pression contre la trace métallique lors de la fixation du capot par exemple par vissage, provoque un léger bombé 121 de la face inférieure 122 de l'embase métallique du module de puissance.

Ainsi selon l'invention, ce bombé de la face inférieure 122 du module de puissance contribue également à une bonne évacutation de la chaleur vers le dissipateur. En effet, lorsque le module de puissance est fixé par exemple par vissage sur le dissipateur 113 au niveau des trous de vissage 111 alors le bombé, sous la pression de vissage assure un parfait plaquage du module de puissance contre l'élément dissipateur 113 assurant de fait un bon contact électrique entre l'embase 109 et le dissipateur 113. Le trou de vissage 111 qui passent selon un mode de réalisation à travers un trou 112 dans l'embase, peut également être réalisé par surmoulage pour sa partie supérieure en PPS pour résister aux efforts de vissage.

En variante, un matériau thermoconducteur tel que du TVI, peut être placé entre le radiateur et le module de puissance. Dans ce cas, la prise de masse se fera par un moyen de connexion électrique, telle qu'une borne, reliant l'embase 109 au niveau de l'évidement 112 vers le capot connecteur, ce moyen passant par exemple à travers un trou 606 du capot. Bien évidement, cette borne sera isolée électriquement du dissipateur 113.

En variante, ce doigt 106 peut être remplacé par une paroi ou une portion de muret moulée sur une partie des traces lors de l'opération de moulage de la ceinture 110. Bien entendu, la hauteur de ce muret sera déterminée en sorte que l'opération de fixation du capot 105 exerce une pression suffisante sur ce muret pour provoquer un léger bombé de l'embase 109.

Les composants de puissance 11 a et 11 b sont reliés entre la masse est la sortie de phase du bobinage statorique. En mode démarreur, ils véhiculent de très forts courants. Les connexions à la masse doivent être les plus courtes possibles pour limiter les échauffements. Une solution consisterait par exemple à amener des plots de masse dans la ceinture 110 et de réaliser ces connexion vers ces plots. Toutefois, la longueur de ces fils serait assez longue.

Une autre solution visible sur la figure 7 consiste à atteindre la masse directement à partir de la plaque métallique 109 formant embase.

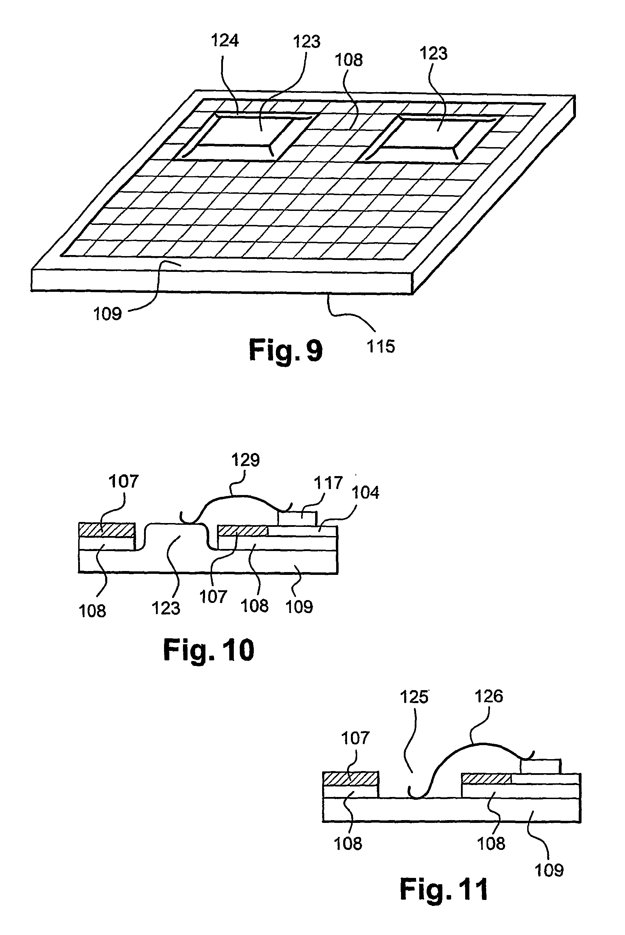

Selon un premier mode de réalisation comme visible aux figure 9 et 10, des bossages 123 sont réalisés sur l'embase. Ces bossages sont destinés à recevoir les fils de connexion 126 pour la formation du circuit de puissance. Ces connexions sont avantageusement de type wire-bonding. Lors de la réalisation de moulage de la résine au niveau des traces métaliques, il faut bien évidement prévoir des évidements 124 dépourvus de résine pour autoriser le passage des plots ou bossage 123 vers le haut. De même, l'isolant 108, tel que du TVI précité, devra avantageusement être prédécoupé pour pouvoir être positionné autour de ces plots 123. Une telle configuration présente l'avantage d'avoir des fils de connexion de courte longueur.

En variante et comme illustré à la figure 11, une ouverture dans la résine 107 et dans l'isolant 108 est réalisée de manière à atteindre directement l'embase métallique 109 constituant la masse. Cette solution permet d'éliminer les bossages 123.

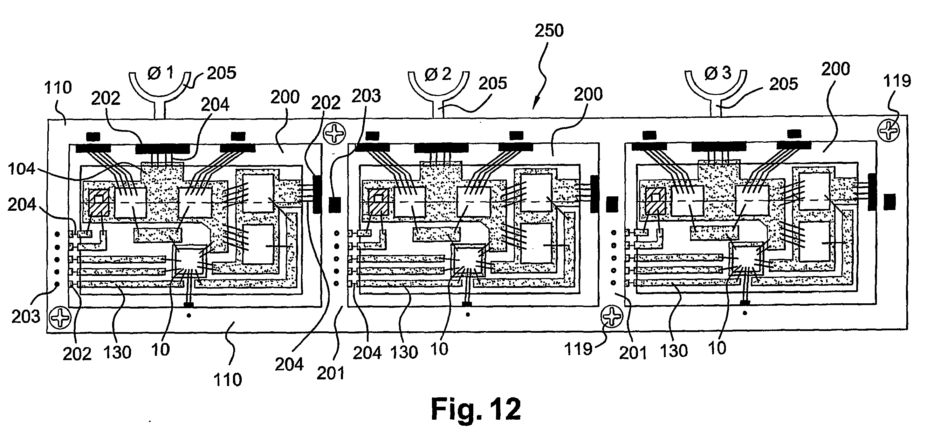

La figure 12 illustre un mode de réalisation d'un module de puissance 250 pour alternateur-démarreur qui intègre toute l'électronique de puissance des trois bras de pont du circuit de commande et de redressement de l'alternateur-démarreur. Ainsi la référence 200 représente un sous-module de puissance. Ce sous-module correspond à l'électronique de puissance d'un bras de pont dédié à une sortie de phase du bobinage du stator de la machine électrique. Le lead-frame de chacun de ces sous-modules correspond par exemple à celui décrit à figure 6.

Ce mode de réalisation présente l'avantage d'être économique d'une part, en nombre de pièce à placer sur le dispositif de refroidissement, et d'autre part, en terme de rebut d'assemblage.

Avantageusement, chacun de ces sous-modules est séparé par une cloison 201. Cette cloison 201 ainsi que la ceinture périphérique 110 sont avantageusement réalisée lors de la même opération de surmoulage. Avantageusement, ces cloisons et cette ceinture renferment des plots de connexions 202 et 203. Comme visible aux figures 7 et 12, les plots 203 orientés vers le haut du module se déclinent en plots 203a de masse, en plot 203b de B+ ou Ua correspondant à la tension du réseau de bord et en plots 203c pour les signaux de faibles puissances. Les plots 202 sont orientés vers les traces métalliques de puissance 104 et de commande 130. Ces plots 202 sont reliés aux traces métalliques précitées par des liaisons filaires de type wire-bonding. Pour connecter les traces métalliques de puissance aux plots 202 correspondants, il est prévu de mettre plusieurs liaisons filaires en parallèle pour véhiculer le courant sans échauffement excessif.

Les plots 205 de puissance sont directement connectés aux fils sorties de phase du bobinage du stator. Ce plot 205 est soumis à de fortes vibrations lors du fonctionnement de la machine électrique tournante. Les liaisons filaires 204 qui relient le plot 205 via le plot 202 correspondant constitue un découplage mécanique et thermique avec le sous-module de puissance qui contribue à augmenter la fiabilité du module de puissance.

Ces plots 202 débouchent vers le haut afin de pouvoir être accessibles au niveau des plots 203. Avantageusement, les plots 202 et 203 sont réalisés directement à partir des traces métalliques composant le Lead-frame du module électronique. Ces traces métalliques étant de forte épaisseur, les plots 203 présenteront une bonne rigidité facilitant leur placement en vue d'une connexion externe, par exemple au moyen d'un capot 511 comportant des traces métalliques.

Un tel module peut être directement fixer sur un dissipateur externe 13.

Selon un premier mode d'assemblage, il est prévu de fixer, par exemple par vissage, la ceinture 110 est les cloisons 201 sur le dissipateur externe. Dans les trois zones dédiées à chacun des sous-modules 200, on dépose sur le dissipateur externe une interface thermique et non conductrice. Avantageusement, cette interface 108 consiste en une colle comportant des billes de verre, ces billes de verre jouant le rôle d'entretoise pour garantir une épaisseur constante entre la face supérieure du dissipateur et les sous-modules de puissance. On dépose ensuite sur cette colle le support constitué par le lead-frame et la résine themoplastique correspondant à chacun de ces sous-modules. Bien évidement toute autre interface thermique et isolante électriquement, telle que du TVI ou le ruban adhésif à double face peut également convenir. Selon un mode de réalisation, ce support correspond à celui décrit à la figure 8 à ceci près qu'il ne comporte pas la ceinture surmoulée 110. Dans ce mode de réalisation, les traces métalliques de puissance 104 sont directement en contact avec le dispositif de refroidissement à travers l'interface thermique ce qui contribue à une bonne évacuation de la chaleur en conséquence du faible nombre d'interfaces thermiques à traverser. En variante, il peut aussi être envisagé de coller un sous-ensemble tel que décrit aux figures 7 ou 8.

Avantageusement, chacun de ces sous-modules est testé avant son assemblage sur le dispositif de refroidissement externe.

Lorsque les sous-modules sont fixés sur le dispositif de refroidissement externe on réalise les connexions filaires 204 entre les traces métalliques 104, 130 et les plots d'interconnexion 202.

A ce stade du procédé d'assemblage du module de puissance, on recouvre avantageusement chacun de ces sous-module d'un gel 120 destiné à garantir l'étanchéité des puces et des connexions à l'humidité et aux pollutions extérieures.

Un capot 105 est enfin appliqué contre la partie supérieure de la ceinture 110. Au droit des plots 203, le capot comporte des ouvertures afin que ces plots 203 traversent le capot aux fins de connexions avec les signaux de puissance (sorties de phase, ou réseau de bord +Ua) ou avec les signaux de contrôle de l'unité de gestion 2.

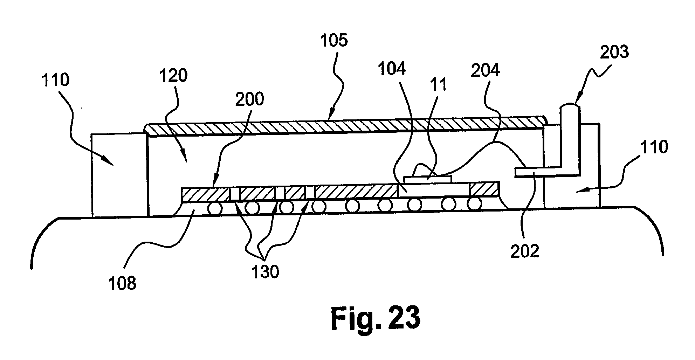

Un tel agencement correspondant à la figure 12 est visible en coupe à la figure 23.

Le module de puissance 250 tel que représenté à la figure 12 présente une forme rectangulaire. Bien entendu, ce module peut se présenter sous la forme d'un demi-arc de cercle pour s'adapter par exemple à l'arrière d'une machine électrique tournante. Il est possible de réaliser cette forme circulaire grâce à la technologie de réalisation du lead-frame de puissance précédemment décrite.

Comme visible à la figure 12, le module de puissance 250 permet d'obtenir une masse isolée accessible par les plots 203a situés dans la ceinture 110. L'avantage de cette masse isolée est justifié notamment lors de la commutation des forts courants qui perturbent les masses des autres équipements électriques. Pour chaque bras de pont, on peut avoir un ou plusieurs plots de masse 203a. Avantageusement, comme pour le plot 203b du B+, on utilisera un seul plot de masse 203a afin de bien équilibrer les courants. Dans ce cas les deux plots de masse 202a seront reliés dans la ceinture de surmoulage pour réaliser la connexion au plus près des transistors et un seul plot de masse 203a sortira vers l'extérieur.

Ce mode d'assemblage préférentiel, dans lequel on vient fixer des modules préalablement testés (bras de pont) présente l'avantage d'être très économique en terme de rebut comparativement à un procédé dans lequel on serait amené à braser en une seul passe toutes les puces formant l'ensemble des trois bras de pont.

Dans le cas ou le dissipateur est électriquement isolé du palier arrière, le dissipateur constitue une masse isolée que l'on connecte à la masse de la batterie directement ou par l'intermédiaire du châssis du véhicule. Dans cette configuration et dans le deuxième mode de réalisation consistant à inclure l'électronique dans un module unique de puissance comme visible à la figure 12, les plots de masses 202a et 203a sont supprimés et sont remplacés par des connexions à la masse similaires à celles décrites aux figures 9 à 11 et dans lesquelles on aura remplacé l'embase 109 par la face supérieure du dissipateur 113.

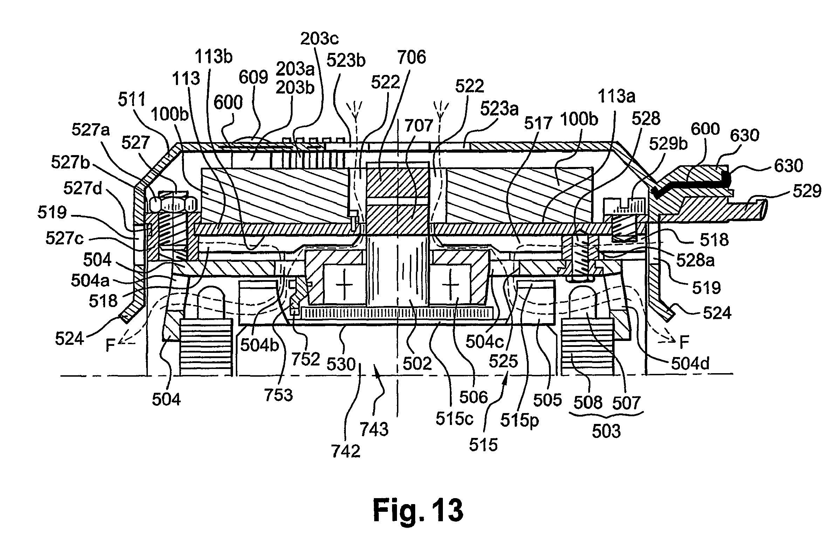

La figure 13 représente une vue de coté en coupe de l'arrière d'un alterno-démarreur à électronique intégrée comportant un agencement de l'électronique de commande et de redressement selon l'invention. Comme tous les alterno-démarreurs connus, l'alterno-démarreur représenté sur la figure 13 comporte un rotor 743 fixé sur un arbre de rotation 502. Ce rotor 743 est entouré par un stator 503, muni d'un bobinage induit 507. Le stator 503 est supporté par le palier arrière 504 et le palier avant (non représenté), qui maintient l'arbre de rotation 502 par l'intermédiaire de roulements 506.

Comme expliqué précédemment, l'alterno-démarreur comporte un pont redresseur à transistors de puissance MOS, associé à des unités de commande de ces transistors de puissance. Ce pont redresseur et ces unités de commande forment ensemble l'électronique de puissance de l'alterno-démarreur. Cette électronique de puissance est montée sur la face supérieure d'un pont dissipateur de chaleur 113 dans un ou plusieurs modules de puissance 100b précédement décrits.

Avantageusement, le module 100a contenant l'unité de gestion 2 est lui aussi montée sur la face supérieure de ce dissipateur pour un bon refroidissement. Cette unité de gestion 2 comporte avantageusement un circuit de contrôle permettant de gérer d'une part les modes démarrage, redémarrage en fonction démarreur et d'autre part la régulation de tension en fonction alternateur. Cette unité peut comporter également l'étage d'excitation du bobinage rotorique qui nécessite également un bon refroidissement.

Selon l'invention, pour bien refroidir les modules de puissance 100b réalisé en un ou plusieurs modules, la face axialement orientée vers le palier arrière de la machine électrique de ce pont dissipateur de chaleur 113 forme une paroi d'un passage longitudinal, ou radial, d'écoulement 517 du fluide de refroidissement dans l'alterno-démarreur. L'autre paroi de ce passage 517 est donc formée par la face supérieure du palier arrière 504. La face inférieure du dissipateur 113 comporte des ailettes 518 formant des canaux de ventilation 517.

Un capot de protection 511 comporte des ouvertures radiales 519 avantageusement situées en regard du passage d'écoulement 517. De cette façon, le fluide de refroidissement, et en particulier l'air, est introduit dans l'arrière de l'alterno-démarreur par ces ouvertures 519 puis circule dans le passage 517, sous le pont dissipateur 113, refroidissant ainsi les module l'électronique de puissance 100b ainsi que le module 100a. Un ventilateur 515 portant des pales 505, fixé sur l'arbre de rotation 502 ou sur le rotor 743, assure l'aspiration de l'air à l'intérieur du passage 517.

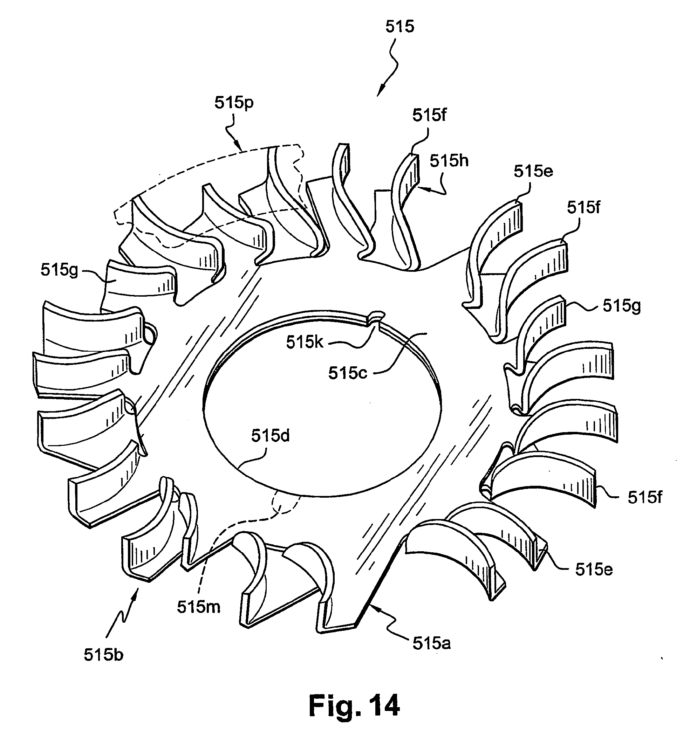

Pour un refroidissement plus efficace le ventilateur 515 peut consister avantageusement en un double ventilateur superposé dont au moins une pale d'un premier ventilateur est positionnée entre au moins deux pales d'un second ventilateur comme visible à la figure 14. Ainsi, comme représenté à la figure 14, le ventilateur 515 comporte selon l'invention au moins deux ventilateurs 515a, 515b, dénommés ci après respectivement premier ventilateur et second ventilateur. Le second ventilateur 515b est destiné à être fixé, par exemple de manière connue par des points de soudage ou par rivetage, sur l'extrémité axiale 530 (la face frontale) concernée de la roue polaire 742 du rotor 743 de la figure 13.

Ici les ventilateurs 515a, 515b sont métalliques en étant économiquement en tôle. Chaque ventilateur comporte une partie de flasque respectivement 515c, sensiblement plane circulaire qui est pourvue d'une ouverture centrale circulaire 515d pour le passage de l'arbre de rotor 502, et une série de pales de ventilation saillantes axialement par rapport au flasque 515c et ménageant entre elles des canaux de ventilation, qui dans cet exemple de réalisation sont divergents vers l'extérieur.

Le premier ventilateur 515a comporte une première série de pales, dites pales primaires 515e, tandis que le second ventilateur 515b comporte une deuxième série de pales, dites pales secondaires 515f.

Ainsi, avantageusement au moins deux pales consécutives d'un des ventilateurs est implantée au moins une pale de l'autre ventilateur.

Les pales primaires 515e sont dans un mode de réalisation radialement plus courtes que les pales secondaires 515f.

Les pales 515e et 515f ont sensiblement radialement la même longueur, la même forme et la même taille axiale en sorte que ces pales sont globalement- identiques à l'exception de deux pales 515g primaires qui sont radialement plus courtes que les autres pales 515e.

Les pales 515e, 515f et 515g sont implantées à la périphérie externe du flasque 515c concerné.

Les pales primaires 515e, 515g sont disposées ici chacune entre deux pales secondaires 515f.

Cette disposition permet d'augmenter la puissance du ventilateur et réduit le risque de décollement de la veine d'air de refroidissement par rapport aux pales. En effet si l'air décolle des pales secondaires 515f, les pales primaires 515e, 515g autoriseront un recollement de l'air sur les pales secondaires 515f. Ainsi chaque pale primaire 515e, 515g est disposée, c'est-à-dire implantée, dans le canal de ventilation 515h ménagé entre les deux pales secondaires adjacentes 515f et qui s'évase en allant de la périphérie interne à la périphérie externe des pales. Dans ce mode de réalisation au moins une pale primaire est donc intercalée entre deux pales secondaires consécutives.

Les pales primaires 515e, 515g et secondaires 515f sont ici obtenues par découpe et pliage à partir de leur flasque métallique concerné 515c et ont avantageusement une forme galbée.

Ainsi les canaux divergents sont délimités en partie par la périphérie externe de l'un des flasques et par les pales.

Les pales primaires et secondaires ont radialement une grande longueur et sont donc très performantes en ce qui concerne la ventilation. Avantageusement, les pales 515e, 515f et 515g ont radialement une longueur supérieure à leur hauteur axiale.

En variante les pales sont planes en étant d'orientation radiale, le ventilateur étant centrifuge. En variante les pales sont inclinées par rapport à une direction axiale et/ou radiale. En variante les pales sont axialement plus hautes que longues radialement.

Le flasque 515c présente ici à sa périphérie externe des portions inclinées découpées avantageusement de manière économique à la presse, qui devient après leur pliage hors du plan du flasque 515c des pales ici galbées. Plus précisément les pales ont radialement en section une forme d'arc de cercle.

Les pales 515e primaires ont pour but de diminuer le bruit de la machine électrique tout en augmentant le débit et le rendement. L'implantation est faite de telle façon que la pale primaire comprime le fluide de refroidissement afin que celui-ci soit en contact avec les pales secondaires 515f. Les recirculations de l'air et les tourbillons sont ainsi empêchées et l'écoulement de l'air est plus laminaire et s'effectue avec peu de frottements et de bruits. Cette disposition permet si besoin est de supprimer le ventilateur avant (non représenté) porté par la roue polaire avant du rotor en sorte que l'alternateur présente en variante un seul ventilateur.

Bien entendu, on pourrait aussi envisager différentes combinaisons de dispositions des pales secondaires 515f avec les pales primaires 515e, 515g. Ainsi, on pourrait disposer plusieurs pales primaires entre les pales secondaires. Le nombre de pales primaires disposé entre les pales secondaires, au sein d'un même dispositif de ventilation 515 peut être constant ou variable. Ici il est disposé une pale secondaire entre deux pales secondaires adjacentes, c'est-à-dire consécutives.

Egalement, on peut envisager d'avoir plusieurs pales secondaires 515f consécutives dépourvues de pales primaires entre elles.

La répartition des pales primaires et secondaires est déterminée en fonction de la machine électrique à refroidir pour obtenir le meilleur refroidissement avec un bruit aérodynamique minimum.

Les pales primaires 515e peuvent être réparties angulairement de façon régulière ou, comme dans le cas représenté sur la figure 14, de façon irrégulière. La disposition irrégulière est obtenue en variante en ayant certaines pales de longueur différente des autres comme les pales 515g de la figure 14.

La disposition irrégulière permet de réduire davantage les bruits de fonctionnement des ventilateurs. Il en est de même des pales secondaires 515f qui peuvent présenter une répartition angulaire irrégulière comme reprsenté à la figure 13. Ainsi, on obtient une série de pales irrégulières divisée en deux parties à raison d'une partie par ventilateur.

En variante un moyen d'isolation thermique, tel qu'un revêtement thermiquement isolant, intervient entre les deux flasques 515c des premiers et seconds ventilateurs, le premier ventilateur 515a pouvant être dans ce cas en matière plastique renforcée par des fibres. Les pales 515e, 515f, 515g s'étendent axialement dans le même sens et perpendiculairement au plan du flasque 515c.

En variante les pales peuvent être inclinées et incurvées par rapport au plan du flasque concerné comme décrit dans le document FR A 2 602 925.

Un moyen d'indexation angulaire intervient entre les deux flasques 515c pour une bonne position angulaire et donc une bonne orientation des pales primaires par rapport aux pales secondaires. Pour ce faire chaque flasque 515c présente à sa périphérie interne une encoche 515k. Les encoches 515k sont ici identiques. Il suffit donc de superposer les encoches par exemple à l'aide d'une pige pour obtenir la bonne position angulaire. Ensuite on fixe ensemble les ventilateurs par exemple par soudage ou rivetage pour former un ensemble manipulable et transportable.

Avantageusement le premier flasque présente au moins un dégagement, tel qu'un trou ou une encoche représentée en pointillé en 515m permettant la fixation du second flasque par exemple par soudage ou rivetage sur le rotor de la machine. De préférence plusieurs trous ou encoches sont prévus.

En variante chaque flasque est fixé par exemple par soudage sur le rotor.

On appréciera que les pales 515e,515f et 515g sont ici toutes axialement à la même hauteur c'est-à-dire que les bords libres des pales sont dans le même plan transversal. Plus précisément les pales 515e, 515g ont axialement une hauteur inférieure aux pales 515f, la différence de largeur étant égale à l'épaisseur du premier flasque 515c.

En variante les pales 515e, 515f sont axialement de hauteur différente, les pales 515f s'étend par exemple en saillie axiale par rapport aux pales 515e, 515g. Il en résulte que les bords libres des pales ne sont pas tous dans le même plan.

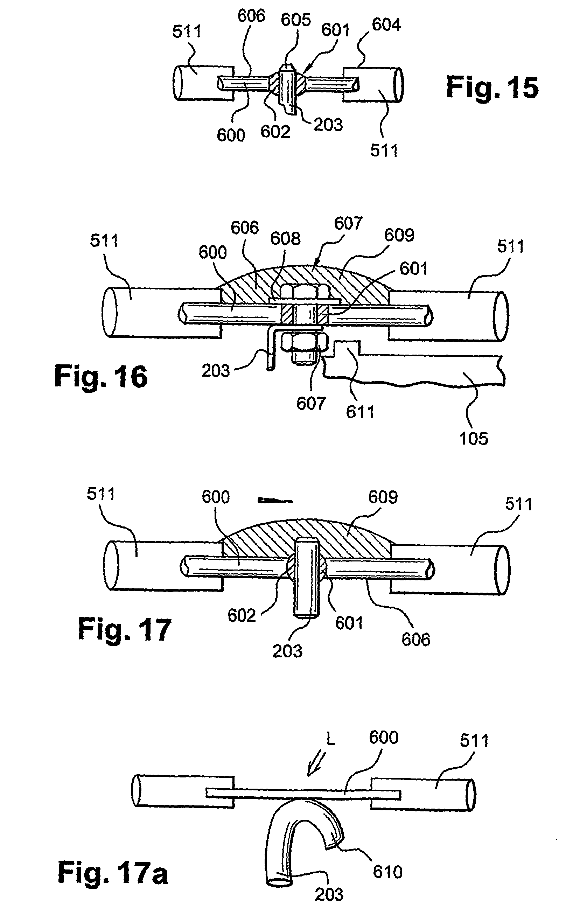

Dans tous les cas il est possible de fixer un couvercle 515p sur le bord libre des pales 515e,515f et 515g ou sur les bords libres les plus éloignées du flasque 515c comme à la figure 16 du document FR A 2 811 156 et comme visible partiellement en pointillés à la figure 14.

En variante au moins une pale de l'un des ventilateurs est dotée, en surplomb, d'une ailette s'étendant de manière inclinée ou perpendiculaire par rapport au plan du flasque du ventilateur concerné comme décrit et visible dans les figures 11 à 13 du document FR A 2 811 156. D'une manière générale grâce à l'invention on peut obtenir les mêmes configurations à deux séries de pales de taille différente que dans le document FR A 2 811 156 précité et ce de manière simple et économique. Par exemple au moins une pale et de préférence certaines au moins des pales, d'au moins un des ventilateurs peuvent être ondulées ou être axialement de hauteur décroissante ou être planes et inclinées par rapport à une direction radiale comme respectivement dans les figures 6, 15 et 2 de ce document.

Grâce à ce dispositif de ventilation 515, on diminue les pertes de charges et les bruits, on augmente le rendement et le débit d'air et on obtient un écoulement stable du fluide de refroidissement procurant ainsi un refroidissement efficace des modules de puissance et de contrôle 100a et 100b. On obtient ainsi un dispositif de ventilation ayant des configurations de pales complexes leur conférant un pouvoir de refroidissement accru, à un coût de revient relativement faible tout en ayant une bonne tenue mécanique.

Pour plus de précisions, on se reportera à la demande de brevet FR 03 02425 déposée le 27 février 2003.

Ainsi réalisé, le pont dissipateur 113 forme une mezzanine au-dessus du palier arrière 504.

Selon l'invention, le pont dissipateur 113 comporte, sur sa face inférieure, des ailettes de refroidissement 518. Ces ailettes de refroidissement sont disposées dans le passage 517 et assurent l'écoulement du fluide de refroidissement selon un chemin choisi, c'est-à-dire de façon à ce que le fluide pénètre au plus près de l'arbre de rotation pour lécher au mieux la face inférieure du pont dissipateur. Ainsi la face inférieure du pont dissipateur est refroidie avantageusement sur toute la distance radiale située entre la périphérie externe et la périphérie interne proche de l'arbre, du pont dissipateur. Les ailettes adjacentes forment des canaux radiaux guidant le fluide de refroidissement dans le passage 517. Ainsi, ces canaux comportent une face inférieure formée par le palier arrière, les deux cotés en regard de deux ailettes adjacentes ainsi que le fond en U du pont dissipateur formé entre deux ailettes adjacentes.

Avantageusement le dissipateur 113, comprenant sur sa face inférieure 113b les ailettes 518, et sur sa face supérieure 113a le/les modules de contrôle et de puissance 100a, 100b est monobloc. En variante, le dissipateur 113 portant les modules de puissance 100b est assemblé sur un dispositif à ailettes formant ainsi un pont dissipateur en deux parties.

Ce fluide s'évacue ensuite par des ouïes 504a -504d réalisées dans le palier arrière 504. Ces ouïes 504a - 504d sont, de préférence, identiques à celles réalisées dans un palier d'alternateur, comme celui montré sur la figure 20. Avantageusement, les ailettes 518 sont disposées radialement dans la direction du flux du fluide se concentrant vers les ouïes centrales 504b et 504c du palier arrière 504.

Ainsi, l'air (ou tout autre fluide de refroidissement) est aspiré latéralement dans l'alterno-démarreur et s'écoule vers les ouïes centrales 504b et 504c du palier 504 tout en léchant les éléments dissipateurs, c'est-à-dire les ailettes 518, sur toute leur longueur avant de s'évacuer par les ouïes latérales 504a et 504d du palier 504. Ainsi, l'électronique de puissance 100b est refroidie par conduction et convection, après refroidissement du pont dissipateur 113, via les ailettes 518.

En outre, comme le pont dissipateur 113 et que les modules de puissance 100b ne sont pas plaqués contre l'arbre de rotation, il existe avantageusement, entre cet arbre de rotation 502 et le pont dissipateur 113, un espace 522 par lequel l'air peut également circuler. Cet espace 522 forme un canal axial d'écoulement du fluide. Selon un mode de réalisation de l'invention des ouïes 523a et 523b sont réalisées dans le capot de protection 511. De l'air est alors aspiré par ces ouïes 523a et 523b dans l'alterno-démarreur, puis s'écoule par l'espace 522 le long de l'arbre de rotation 502 et rejoint le passage d'écoulement 517 sous le pont dissipateur 113 ce qui contribue à améliorer le refroidissement du dissipateur 113. De cette façon, l'électronique de puissance est refroidie, d'une part, latéralement par le passage 517 et, d'autre part, axialement par l'espace 522. Cet écoulement d'air axial supplémentaire transitant par l'espace 522 permet en outre d'obtenir un bien meilleur refroidissement des parties internes de l'alternateur, telles que la cage porte-balais ou que les chignons des bobinages induits, par une augmentation du débit d'air global dans la machine.

Le chemin de l'écoulement du fluide de refroidissement à l'arrière de l'alterno-démarreur est représenté par des flèches F et des traits pointillés, sur la figure 13.

Selon un mode de réalisation préféré de l'invention, des déflecteurs 524 sont placés en aval des ouïes 504a et 504d réalisées dans le palier arrière 504. Ces déflecteurs 524 permettent d'éloigner le flux de fluide d'entrée du flux de fluide de sortie afin que le fluide sortant de l'alterno-démarreur ne soit pas réintroduit immédiatement dans le passage 17. On évite ainsi une recirculation importante du fluide chaud provenant de l'intérieur de l'alterno-démarreur.

Ces déflecteurs 524 peuvent d'être fixés sur le palier 504, à proximité des ouïes latérales 504a et 504d du palier. Ils peuvent également être réalisés dans le capot de protection 511, par exemple, en relevant les extrémités du capot de protection, comme représenté sur la figure 13.

Dans le mode de réalisation de l'invention représenté sur la figure 13, le capot de protection 511 enveloppe toute la partie arrière de l'alterno-démarreur, c'est-à-dire qu'il enveloppe l'électronique de puissance 100b, 100a montée sur le pont dissipateur 113 et la totalité du palier arrière 504. Dans ce cas, le capot de protection 511 peut comporter des ouïes situées en aval des ouïes latérales du palier arrière et destinées à laisser s'évacuer le fluide hors de l'alterno-démarreur. Il peut aussi comporter, en plus ou à la place de ces ouïes, des déflecteurs 524. Ceux-ci peuvent être réalisés dans le capot lui-même.

Le capot de protection 511 peut aussi envelopper l'électronique de puissance montée sur le pont dissipateur et la partie supérieure du palier 504, c'est-à-dire qu'il n'enveloppe pas les cotés latéraux du palier comportant les ouïes 504a et 504d. Dans ce cas, les déflecteurs peuvent être fixés sur le palier 504 ou bien réalisés en relevant l'extrémité du capot.

Comme représenté à la figure 13, le ventilateur 515 porte à l'extrémité axiale d'au moins une partie de ces pales 505 un couvercle 515p. Ce couvercle oblige le flux d'air F à passer au niveau des pales 505 du ventilateur ce qui favorise ainsi un meilleur refroidissement des chignons 507 du bobinage statorique et de l'électronique portée par le dissipateur.

Avantageusement, le bord externe 525 de l'ouie 504b et 504d réalisée dans le palier arrière 504 est sensiblement au droit du bord interne des pales 505 de manière à faire passer tout le flux de refroidissement F entre les pales 505 du ventilateur. Ainsi, seul un flux résiduel peut passer entre le sommet du capot 515p et la face inférieure axiale du palier arrière 504.

Avantageusement, les ouies 504b et 504d sont à proximité du logement du roulement 506 en sorte qu'il peut être efficacement refroidi et cela d'autant plus si le ventilateur consiste en la superposition de deux ventilateurs comme décrit précédement.

Selon un premier mode de réalisation, et comme visible à la figure 13, le dissipateur 113 est électriquement isolé du palier arrière 504. Ainsi, le dissipateur 113 constitue une masse isolée pour notamment l'électronique de puissance contenue dans le/les modules 100b l'électronique de l'unité de gestion 2. Isoler électriquement le dissipateur du palier arrière contribue à obtenir de meilleures performances en terme de compatibilité électromagnétique et de thermique.

Selon une première variante de réalisation le pont dissipateur 113 est fixé sur le palier arrière 504 au moyen de tirants d'assemblage 527 électriquement isolés et avantageusement thermiquement non conducteurs constituant ainsi un barrage thermique par rapport à la chaleur émanant du stator.

Avantageusement, les tirants 527 sont les mêmes que ceux utilisés pour fixer habituellement le palier 504 avec le circuit magnétique 508 du stator 503. Une rondelle électriquement isolante 527b est interposée entre l'écrou de blocage 527a et la face supérieure 113a du dissipateur 113. Une entretoise 527c comportant un épaulement 527d est interposée entre la face inférieure 113b du dissipateur et la face externe axiale du palier arrière 504.

Selon une seconde variante, le dissipateur 113 est solidarisé avec le palier arrière 504 de manière électriquement isolée au moyen d'une vis 528 dont la tête est orientée du coté de la face inférieure axiale du palier 504. Dans ce mode de réalisation une entretoise électriquement non condutrice 528a est placée entre la face inférieure 113b du dissipateur 113 et la face axiale supérieure du palier arrière 504. La vis 528 vient en appui contre un canon électriquement isolant à épaulement placé dans l'épaisseur axial du palier arrière 504.

Bien évidement, d'autre moyens de fixation du dissipateur sur le palier peuvent être envisagés.

Bien évidement, les entretoises 527c ou 528a peuvent être solidaires du pont dissipateur 113 ou bien du palier 504 pour constituer des plots de fixation. Dans ce cas, des moyens d'isolation électriques et thermiques telles que des rondelles isolantes devront être placées à l'extrémité de ces plots de fixation.

Le dissipateur portant l'électronique de commande et de puissance est ainsi placé à distance de la face externe axiale du palier arrière de la machine électrique tournante pour constituer une mezzanine refroidie par de l'air introduit principalement radialement entre cette mezzanine et la face supérieure axiale du palier arrière.

Selon un mode de réalisation décrit à la figure 7, le module de puissance 100b est mis à la masse par un contact électrique direct entre l'embase 109 et la face supérieure 113a du dissipateur.

Un cable de masse 529, électriquement connecté au dissipateur par un moyen de fixation 529b tel que vissage ou soudage, est avantageusement relié à la borne négative de la batterie du véhicule automobile pour constituer une masse isolée.

Comme décrit précédement les plots 203 correspondants aux connexions des signaux ou de contrôle issus du ou des modules de puissance 100b sont orientés axialement vers l'arrière de la machine électrique aux fins de connexion électrique. Avantageusement, ces plots 203 atteignent le capot 511 en matière plastique qui contient par surmoulage des traces métalliques de puissance et de contrôle. Avantageusement, le capot renferme toute les traces métalliques permettant de réaliser toutes les connexions entre d'une part, les modules de puissance, et d'autre part, les modules de puissance 100b avec l'unité de gestion 2. Ainsi, cette agencement présente l'avantage de ne pas réaliser de connexions filaires sous le capot, ce qui procure un gain économique non négligeable. En effet, toutes les connexions de faible et forte puissance sont réalisées en une seule passe au niveau de l'assemblage du capot doté de traces métalliques. La suppression de ces connexions filaires sous le capot permettent de gagner de la place est de réduire ainsi par exemple la longueur axiale de la machine.

Les figures 15 et 16 et 17 et 17a décrivent des moyens possibles de connexion électrique entre les plots 203 et les traces métalliques contenues 600 dans le capot 511 par surmoulage.

Comme représenté à la figure 15 le plot 203 passe à travers un orifice 601, fermé ou semi-fermé, réalisé dans la trace 600 à connecter. Avantageusement l'extrémité du plot 203 sort de l'autre coté de la trace 600 pour fixation par un moyen de soudure. La référence 602 montre la soudure ainsi réalisée.

Avantageusement, l'extrémité 605 du plot 203 est sensiblement à la même hauteur axiale, de préférence à une hauteur moindre, que le bord axial supérieur du capot 511 pour éviter de détériorer ces soudure lors de manipulations de la machine électrique. Ces traces métalliques sont accessibles à la faveur d'ouvertures 606 réalisées dans le capot arrière 511.

La forme du plot 203 est adapté à sa tolérance de positionnement.

La figure 16 illustre une variante de réalisation d'une liaison électrique entre un plot 203, avantageusement de puissance et sa trace métallique associée par un moyen de vissage de type boulon-écrou. De manière connue en soi, une rondelle fendue de type Grover 608 est interposée entre la face inférieure du boulon et la face externe de la trace métallique alors que le plot 103 est pincé entre l'écrou et la face inférieure de la trace métallique. Dans ce mode de réalisation, avantageusement, une partie 611 du capot 105 du module 100b comprenant un ou les trois bras de pont, vient en contact avec l'écrou 607 pour son blocage en rotation aux fins de vissage.

La figure 17 illustre une connexion réalisée par soudure comme décrite à la figure 15 comportant une protection de type vernis, colle, ou silicone pour éviter les agressions chimiques de type brouillard salin ou humidité. Cette protection est aussi applicable pour le moyen de fixation par boulon écrou décrit à la figure 15.

La figure 17a illustre une connexion réalisée par soudure de type laser L dans laquelle le plot 203 ne traverse pas la trace métallique. Dans ce cas, la trace 203 présente une courbure 610 adaptée pour venir en contact sous contrainte avec la trace métallique 600 lorsque le capot 511 est monté sur l'arrière de la machine électrique. Ce mode de réalisation présente l'avantage d'avoir un capot 511 bien hermétique.

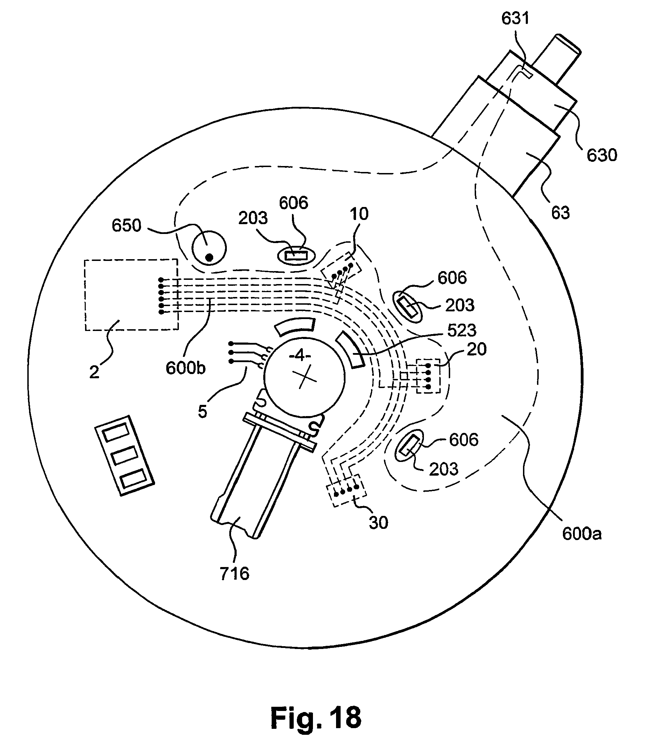

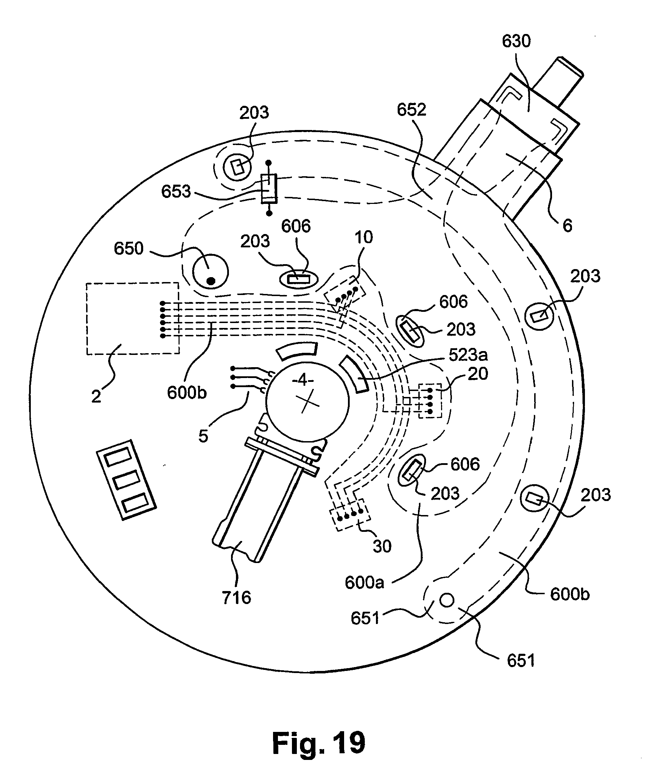

La figure 18 illustre un capot arrière selon l'invention vue de l'arrière de la machine électrique tournante. Ce mode de réalisation correspond au cas où le dissipateur 113 formant mezzanine est isolé électriquement du palier arrière 504. Ainsi avantageusement, le capot 511 ne comporte qu'une seule trace métallique 600a de forte puissance est capable de faire transiter des courant d'environ 1000 ampères lors de phases de démarrage. Cette trace métallique 600a, qui englobe avantageusement la connexion 650 B+ du porte-balais, et dédiée à la borne positive B+ connectée au réseau électrique du véhicule automobile peut donc être dessinée en occupant toute la place qui lui est nécessaire sans interférer avec l'autre de 600b de masse nécessaire lorsque la mezzanine n'est pas isolée et comme illustré à la figure 19.

Comme visible aux figures 18 et 19, il est ainsi très facile de connecter les drivers 10, 20 et 30, placés centralement proche de l'arbre de rotation, avec le module de gestion 2 précédemment décrit. Ainsi, selon l'invention, il est possible d'obtenir une machine électrique de type alternateur-démarreur comportant sur son palier arrière et solidaire mécaniquement, toute l'électronique de puissance, de commande et de contrôle nécessaire à son fonctionnement. Bien évidement, selon le cas, des fonctions électroniques peuvent être déportées dans un boîtier externe sans sortir du cadre de l'invention. L'architecture du palier arrière tel que décrit précédemment permet également un très bon refroidissement de son ou ses modules de puissances grâce à sa structure en forme de mezzanine refroidie par un fluide de refroidissement à introduction radiale et avantageusement axiale en complément. Ce refroidissement est d'autant plus efficace que le/les modules électroniques de puissance sont réalisés conformément aux figures 6 à 12 . L'intégration de l'électronique de puissance en un ou plusieurs modules, avantageusement connectés par l'intermédiaire de traces surmoulées dans le capot permet un montage extrêmement aisé de l'électronique de puissance et/ou de commande de l'alternateur-démarreur donc économique. De plus l'intégration des traces métalliques de puissance dans le capot permet de placer aisément le connecteur 630 en tout endroit du capot pour s'adapter à la configuration du véhicule automobile.

La figure 19 constitue une seconde variante de réalisation du capot 511 comportant les traces métalliques selon l'invention pour un dissipateur formant mezzanine au même potentiel électrique que le palier arrière 504. Dans ce cas les modules de puissance sont électriquement isolés par rapport au dissipateur Dans ce mode de réalisation, il n'est plus nécessaire d'isoler électriquement les entretoises 527c ou 528a formant des plots de fixation précédemment décrites. Ainsi, les rondelles ou canons électriquement isolants placés à l'extrémité de ces plots de fixation ou entre la mezzanine et le palier arrière peuvent être supprimés conférant ainsi à l'ensemble palier arrière-mezzanine plus de rigidité mécanique.

Dans ce mode de réalisation, le capot intègre, en plus ce celles décrites à la figure 18, la trace de puissance 600b dédiée à la masse. Pour atteindre le connecteur 630 les deux traces de puissance 600a et 600b se chevauchent dans une zone 652 du capot qui présente avantageusement à cet endroit une surépaisseur afin que les deux traces demeurent surmouler à cet endroit. A cet endroit, le surmoulage des traces sera réalisé de manière à garantir l'isolation électrique. Pour effectuer ce croisement, au moins une des deux traces présentera au moins une portion coudée.

Dans ce mode de réalisation la connexion 651 de la masse du porte-balai est aussi avantageusement réalisée par la trace de masse 600b.

Comme visibles aux figures 18 et 19, il est également prévu un connecteur 653 destiné à communiquer avec un boîtier électronique externe par exemple par l'intermédiaire d'un protocole connu de type Can, Lan, Lin, BSP ou par simple liaison filaire.

Avantageusement des condensateurs de filtrage 653, comme visible à la figure 19, peuvent être connecté par l'intermédiaire du capot 511. Ces condensateur 653, soudés entre les traces de puissance Ua et la masse, font partie intégrante du capot par exemple, par surmoulage, clipsage, collage. De la même manière, on peut placer des condensateur entre les traces métalliques de faible puissance du capot.

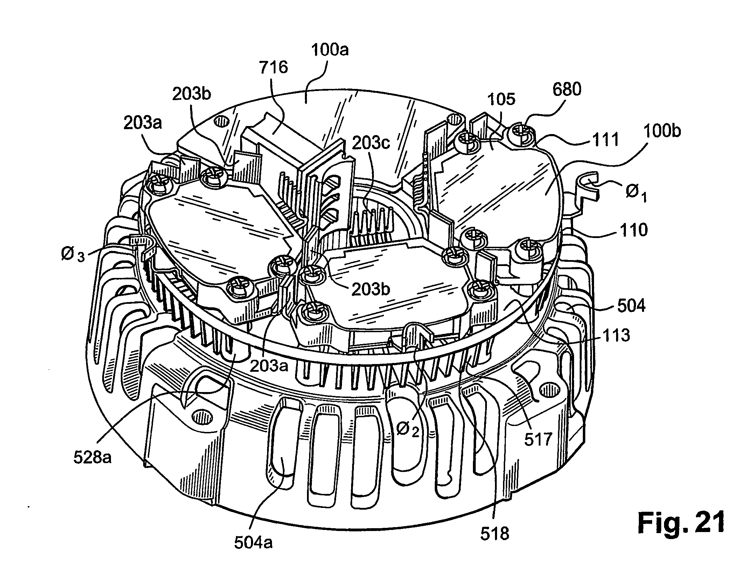

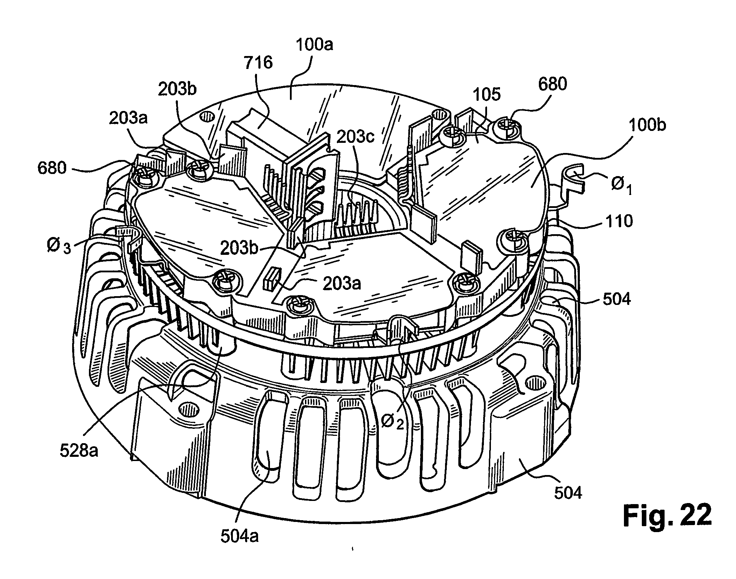

Les figures 21 et 22 illustrent deux modes de réalisation d'un palier arrière d'alternateur intégrant son électrique de commande et de contrôle sur un palier dissipateur 113 formant mezzanine selon l'invention.

Dans ces deux figures, les plots de fixation 528a ne sont pas électriquement isolés en sorte que le palier dissipateur 113 n'est pas isolé électriquement. Les masses des modules électroniques 100b sont donc rapportés au niveau des plots 203a.

La figure 21 correspond à l'électronique de puissance 100b répartie en trois modules, chacun correspondant à un bras de pont et comme décrit à la figure 7 alors que la figure 21 correspond à l'agencement de l'électronique de puissance intégrant les trois bras de pont en un module unique comme décrit à la figure13.

Dans ces deux figures, la référence 100a représente l'emplacement dédié au module 100a de gestion 2 qui possède également des plots 203c de connexion.

Comme visible à la figure 21, les plots 203a et 203b de puissance sont jointifs de manière à être connecté électriquement en une seule passe par exemple au niveau des traces métalliques du capot 511 comme décrit précédemment.

Des vis 680 insérées par exemples dans les logement 111 des modules de puissance 100b assurent la fixation de ces modules de puissance sur le dissipateur 113.

## Revendications

1. Module de contrôle et de puissance (100) d'un alternateur-démarreur polyphasé pour véhicule automobile, connecté aux phases de l'alternateur-démarreur (3) , au réseau de bord (Ua) et à une ligne de masse (GND) du véhicule, comportant:
- une unité de puissance (1) comprenant un pont de transistors de puissance à plusieurs branches (B1 - B3), chaque branche correspondant a une phase de l'alternateur-demarreur
- une unité de contrôle (50) comparant une tension de phase (e) de l'alternateur-demarreur avec une tension de référence (Va, GND) et commandant les transistors en fonction du résultat de la comparaison,
**caractérisé en ce qu'**il comporte
un premier étage (100b) intégré audit alternateur-démarreur (3) et formé d'une pluralité de sous-modules électroniques de puissance intégrés et compacts (100b; 200), chaque dit sous-module électronique de puissance (100b; 200) étant disposé au niveau d'une sortie de phase respective (ϕ₁, ϕ₂, ϕ₃) de bobinage statorique de l'alternateur-démarreur,
un second étage (100a) formé d'un boîtier distinct desdits sous-modules électroniques de puissance (100b, 200) et comprenant un circuit de gestion (2),
chaque dit sous-module électronique de puissance (100b, 200) intégrant une branche (B1, B2, B3) dudit pont de transistors de puissance et un circuit driver (10, 20, 30) pilotant tous les transistors de puissance (11, 12 ; 21, 22; 31, 32) de ladite branche (B1, B2, B3) et implanté au plus près desdits transistors de puissance, et ledit circuit de gestion (2) contrôlant le fonctionnement de l'ensemble desdits circuits driver (10, 20, 30) et formant avec ceux-ci ladite unité de contrôle (50).

2. Module de contrôle et de puissance selon la rendication 1, **caractérisé en ce qu'**il est intégré à l'arrière de l'alternateur-démarreur.

3. Module de contrôle et de puissance selon l'une des revendications 1 ou 2 **caractérisé en ce que** le second étage est placé dans un boîtier extérieur à l'alternateur-démarreur.

4. Module de contrôle et de puissance selon l'une quelconque des revendications 1 à 3, **caractérisé en ce qu'**il est destiné à être connecté à un alterno-démarreur triphasé dont chaque phase est connecté à une des branches (B1, B2, B3) de l'unité de puissance et **en ce que** ces trois branches sont identiques.

5. Module de contrôle et de puissance selon l'une quelconque des revendications 1 à 4, **caractérisé en ce que** des commandes du circuit de gestion (2) sont communes à tous les drivers.

6. Module de contrôle et de puissance selon l'une quelconque des revendications 1 à 5, **caractérisé en ce que** chaque transistor est un ensemble de transistors connectés en parallèle.

7. Module de contrôle et de puissance selon l'une quelconque des revendications 1 à 6, **caractérisé en ce que** chaque driver (10, 20, 30) reçoit en entrée des signaux (ALG, SC, VA, VD) provenant du circuit de gestion (2).

8. Module de contrôle et de puissance selon l'une quelconque des revendications 1 à 7, **caractérisé en ce que** chaque driver (10, 20, 30) reçoit en entrée des signaux de mesure (MVA, MGND, MPH,) respectivement du potentiel du réseau de bord (UA), du potentiel de la masse (GND) et du potentiel des phases (PH).

9. Module de contrôle et de puissance selon la revendication précédente, **caractérisé en ce que** chaque driver est situé à proximité des potentiel (PH, UA, GND) à mesurer en sorte que les connexions des signaux de mesure (MPH, MVA, MGND) sont de longueur réduite pour diminuer leur sensibilité aux perturbations.

10. Module de contrôle et de puissance selon la revendication 8 ou 9, **caractérisé en ce que** les connexions des signaux de mesure (MPH, MVA, MGND) sont connectés au potentiel de masse (GND) des transistors de puissance (12, 22, 32) au potentiel d'alimentation (UA) des transistors de puissance (11, 21, 31) et au potentiel de phase (PH) des transistors de puissance (11, 12, 21, 22, 31, 32)

11. Module de contrôle et de puissance selon l'une quelconque des revendications 8 à 10, **caractérisé en ce que** les signaux de mesure issus du circuit de puissance sont connectés à deux comparateurs (C11, C12) du driver (10, 11, 12).

12. Module de contrôle et de puissance selon l'une quelconque des revendications précédentes, **caractérisé en ce que** chaque driver (10, 20, 30) est contrôlé par le même circuit de gestion (2).

13. Module de contrôle et de puissance selon l'une quelconque des revendications précédentes, **caractérisé en ce que** les drivers (10, 20, 30) pilotent chacun les transistors (11, 12, 21, 22, 31, 32) de puissance d'une même branche (B1, B2, B3).

14. Module de contrôle et de puissance selon la revendication précédente, **caractérisé en ce que** chaque branche du pont comporte au moins deux transistors de puissance dotés chacun d'une grille et **en ce que** les drivers (10, 20, 30) sont connectés, en sortie, aux grilles des deux transistors (11, 12; 21, 22; 31, 32) de puissance d'une même branche.

15. Module de contrôle et de puissance selon la revendication 14, **caractérisé en ce que** les drivers (10, 20, 30) comparent les potentiels de phase (ϕ1, ϕ2, ϕ3) de l'alterno-démarreur avec le potentiel de masse du pont redresseur pour la commande de l'un des transistors (12, 22, 32) et avec le potentiel de sortie Ua du pont redresseur pour la commande de l'autre transistor (11, 21, 31).

16. Module de contrôle et de puissance selon la revendication 14 ou 15 **caractérisé en ce que** les drivers (10, 20, 30) reçoivent du circuit de gestion (2) un signal (ALG) d'alimentation des grilles des transistors (11, 12, 21, 22, 31, 32).

17. Module de contrôle et de puissance selon la revendication 16, **caractérisé en ce que** le signal (ALG) d'alimentation est fourni par une source auxiliaire.

18. Module de contrôle et de puissance selon la revendication 16 ou 17, **caractérisé en ce que** la tension du signal (ALG) délivrée par le circuit de gestion (2) est de 16 Volts +/-1 Volt.

19. Module de contrôle et de puissance selon l'une quelconque des revendications 17 à 18, **caractérisé en ce que** les drivers (10, 20, 30) reçoivent du circuit de gestion (2) un signal (SC) représentatif des informations fournies par des capteurs de position du rotor de l'alternateur-démarreur pour indiquer la position du rotor que comporte l'alternateur démarreur.

20. Module de contrôle et de puissance selon l'une quelconque des revendications 7 à 18, **caractérisé en ce que** les drivers (10, 20, 30) reçoivent du circuit de gestion (2) un signal (VA, VD) de validation du mode de fonctionnement de l'aitemateur-démarreur en mode alternateur ou en mode démarreur.

21. Module de contrôle et de puissance selon la revendication 14, **caractérisé en ce que** les drivers (10, 20, 30) comportent un circuit logique (13) et des sources de courant (S11, S12) pour commander les grilles des transistors de puissance en fonction des signaux reçus sur les entrées du driver.

## Claims

1. Control and power module (100) for a polyphase alternator-starter for a motor vehicle, which is connected to the phases of the alternator-starter (3), to the on-board network (Ua) and to a ground line (GND) of the vehicle, comprising:
- a power unit (1) comprising a bridge of power transistors with a plurality of branches (B1 - B3), each branch corresponding to a phase of the alternator-starter; and
- a control unit (50) which compares a phase voltage (ϕ) of the alternator-starter with a reference voltage (Va, GND), and commands the transistors according to the result of the comparison,
**characterised in that** it comprises:
a first stage (100b) which is integrated in the said alternator-starter (3), and is formed by a plurality of compact, integrated electronic power sub-modules (100b; 200), each said electronic power sub-module (100b; 200) being disposed at the level of a respective stator winding phase output (ϕ₁, ϕ₂, ϕ₃) of the alternator-starter; and
a second stage (100a) formed by a housing which is distinct from the said electronic power sub-modules (100b, 200), and comprises a control circuit (2),
each said electronic power sub-module (100b, 200) incorporating a branch (B1, B2, B3) of the said power transistor bridge and a driver circuit (10, 20, 30) which controls all the power transistors (11, 12; 21, 22; 31, 32) of the said branch (B1, B2, B3), and is implanted as close as possible to the said power transistors, and the said control circuit (2) controlling the functioning of the assembly of the said driver circuits (10, 20, 30), and forming the said control unit (50) together with the latter.

2. Control and power module according to claim 1, **characterised in that** it is integrated in the rear of the alternator-starter.

3. Control and power module according to one of claims 1 or 2, **characterised in that** the second stage is placed in a housing outside the alternator-starter.

4. Control and power module according to any one of claims 1 to 3, **characterised in that** it is designed to be connected to a three-phase alternator-starter, each phase of which is connected to one of the branches (B1, B2, B3) of the power unit, and **in that** these three branches are identical.

5. Control and power module according to any one of claims 1 to 4, **characterised in that** commands of the control circuit (2) are common to all the drivers.

6. Control and power module according to any one of claims 1 to 5, **characterised in that** each transistor is an assembly of transistors connected in parallel.

7. Control and power module according to any one of claims 1 to 6, **characterised in that** each driver (10, 20, 30) receives as input signals (ALG, SC, VA, VD) which are obtained from the control circuit (2).

8. Control and power module according to any one of claims 1 to 7, **characterised in that** each driver (10, 20, 30) receives as input signals (MVA, MGND, MPH) respectively of measurement of the on-board network potential (UA), the ground potential (GND) and the phase potential (PH).

9. Control and power module according to the preceding claim, **characterised in that** each driver is situated in the vicinity of the potentials (PH, UA, GND) to be measured, such that the connections of the measurement signals (MPH, MVA, MGND) have a reduced length, in order to reduce their sensitivity to disturbances.

10. Control and power module according to claim 8 or 9, **characterised in that** the connections of the measurement signals (MPH, MVA, MGND) are connected to the ground potential (GND) of the power transistors (12, 22, 32), to the supply potential (UA) of the power transistors (11, 21, 31), and to the phase potential (PH) of the power transistors (11, 12, 21, 22, 31, 32).

11. Control and power module according to any one of claims 8 to 10, **characterised in that** the measurements signals which are obtained from the power circuit are connected to two comparators (C11, C12) of the driver (10, 11, 12).

12. Control and power module according to any one of the preceding claims, **characterised in that** each driver (10, 20, 30) is controlled by the same control circuit (2).

13. Control and power module according to any one of the preceding claims, **characterised in that** the drivers (10, 20, 30) each control the power transistors (11, 12, 21, 22, 31, 32) of a single branch (B1, B2, B3).

14. Control and power module according to the preceding claim, **characterised in that** each branch of the bridge comprises at least two power transistors, which are each provided with a gate, and **in that** the drivers (10, 20, 30) are connected at the output to the gates of the two power transistors (11, 12; 21, 22; 31, 32) of a single branch.

15. Control and power module according to claim 14, **characterised in that** the drivers (10, 20, 30) compare the phase potentials (ϕ₁, ϕ₂, ϕ₃) of the alternator-starter with the ground potential of the rectifier bridge for the control of one of the transistors (12, 22, 32), and with the output potential Ua of the rectifier bridge for the control of the other transistor (11, 21, 31).

16. Control and power module according to claim 14 or 15, **characterised in that** the drivers (10, 20, 30) receive from the control circuit (2) a supply signal (ALG) for the transistor gates (11, 12, 21, 22, 31, 32).

17. Control and power module according to claim 16, **characterised in that** the supply signal (ALG) is provided by an auxiliary source.

18. Control and power module according to claim 16 or 17, **characterised in that** the voltage of the signal (ALG) which is supplied by the control circuit (2) is 16 Volts +/-1 Volt.

19. Control and power module according to any one of claims 7 to 18, **characterised in that** the drivers (10, 20, 30) receive from the control circuit (2) a signal (SC) which is representative of the information provided by sensors for the position of the rotor of the alternator-starter, in order to indicate the position of the rotor which the alternator-starter comprises.

20. Control and power module according to any one of claims 7 to 18, **characterised in that** the drivers (10, 20, 30) receive from the control circuit (2) a signal (VA, VD) for validation of the mode of functioning of the alternator-starter, in alternator mode or in starter mode.

21. Control and power module according to claim 14, **characterised in that** the drivers (10, 20, 30) comprise a logic circuit (13) and current sources (S11, S12) in order to command the gates of the power transistors according to the signals received at the inputs of the driver.

## Patentansprüche

1. Steuer- und Leistungsmodul (100) für einen mehrphasigen Starter-Generator eines Kraftfahrzeugs, das an die Phasen des Starter-Generators (3), an das Bordnetz (Ua) und an die Masseleitung (GND) des Fahrzeugs angeschlossen ist, umfassend
- eine Leistungseinheit (1) mit einer Leistungstransistorbrücke mit mehreren Brückenzweigen (B1 - B3), wobei jeder Brückzweig einer Phase des Starter-Generators entspricht, und
- eine Steuereinheit (50), die eine Phasenspannung (ϕ) des Starter-Generators mit einer Referenzspannung (Va, GND) vergleicht und die Transistoren in Abhängigkeit von dem Ergebnis dieses Vergleichs steuert,
**dadurch gekennzeichnet, dass** es umfasst:
- eine erste Stufe (100b), die in den besagten Starter-Generator (3) integriert und aus einer Mehrzahl von integrierten und kompakten elektronischen Leistungs-Submodulen (100b; 200) gebildet ist, wobei jedes der besagten elektronischen Leistungs-Submodule (100b; 200) an einem entsprechenden Phasenausgang (ϕ1, ϕ2, ϕ3) der Statorwicklung des Starter-Generators angeordnet ist,
- eine zweite Stufe (100a), die aus einem Gehäuse gebildet ist, das von den besagten elektronischen Leistungs-Submodulen (100b, 200) getrennt ist, und die eine Steuerschaltung (2) umfasst,
wobei jedes der elektronischen Leistungs-Submodule (100b, 200) einen Brückenzweig (B1, B2, B3) der besagten Leistungstransistorbrücke und eine Treiberschaltung (10, 20, 30) umfasst, die alle Leistungstransistoren (11, 12; 21, 22; 31, 32) des besagten Brückenzweiges (B1, B2, B3) steuert und möglichst nah an den Leistungstransistoren angeordnet ist, und die besagte Steuerschaltung (2) die Funktion aller Treiberschaltungen (10, 20, 30) steuert und mit diesen die besagte Steuereinheit bildet (50).

2. Steuer- und Leistungsmodul nach Anspruch 1, **dadurch gekennzeichnet, dass** es hinter dem Starter-Generator angeordnet ist.

3. Steuer- und Leistungsmodul nach einem der Ansprüche 1 oder 2, **dadurch gekennzeichnet, dass** die zweite Stufe in einem Gehäuse außerhalb des Starter-Generators angeordnet ist.

4. Steuer- und Leistungsmodul nach einem der Ansprüche 1 bis 3, **dadurch gekennzeichnet, dass** es für den Anschluss an einen dreiphasigen Starter-Generator bestimmt ist, bei dem jede Phase an einen der Brückenzweige (B1, B2, B3) der Leistungseinheit angeschlossen ist, und dass diese drei Brückenzweige identisch sind.

5. Steuer- und Leistungsmodul nach einem der Ansprüche 1 bis 4, **dadurch gekennzeichnet, dass** Befehle der Steuerschaltung (2) für alle Treiber dieselben sind.

6. Steuer- und Leistungsmodul nach einem der Ansprüche 1 bis 5, **dadurch gekennzeichnet, dass** jeder Transistor eine Gesamtheit von parallelgeschalteten Transistoren ist.

7. Steuer- und Leistungsmodul nach einem der Ansprüche 1 bis 6, **dadurch gekennzeichnet, dass** jeder Treiber (10, 20, 30) eingangsseitig Signale (ALG, SC, VA, VD) von der Steuerschaltung (2) empfängt.

8. Steuer- und Leistungsmodul nach einem der Ansprüche 1 bis 7, **dadurch gekennzeichnet, dass** jeder Treiber (10, 20, 30) eingangsseitig Messsignale (MVA, MGND, MPH,) des Potenzials des Bordnetzes (UA), des Potenzials der Masse (GND) beziehungsweise des Potenzials der Phasen (PH) empfängt.

9. Steuer- und Leistungsmodul nach dem vorhergehenden Anspruch, **dadurch gekennzeichnet, dass** jeder Treiber in der Nähe der Potenziale (PH, UA, GND) angeordnet ist, die zu messen sind, so dass die Messsignalverbindungen (MPH, MVA, MGND) von begrenzter Länge sind, um ihre Störempfindlichkeit zu mindern.

10. Steuer- und Leistungsmodul nach Anspruch 8 oder 9, **dadurch gekennzeichnet, dass** die Messsignalverbindungen (MPH, MVA, MGND) an das Massepotenzial (GND) der Leistungstransistoren (12, 22, 32), an das Versorgungspotenzial (UA) der Leistungstransistoren (11, 21, 31) und an das Phasenpotenzial (PH) der Leistungstransistoren (11, 12, 21, 22, 31, 32) angeschlossen sind.

11. Steuer- und Leistungsmodul nach einem der Ansprüche 8 bis 10, **dadurch gekenntzeichnet, dass** die Messsignale der Leistungsschaltung an zwei Komparatoren (C11, C12) des Treibers (10, 11, 12) angeschlossen sind.

12. Steuer- und Leistungsmodul nach einem der vorhergehenden Ansprüche, **dadurch gekennzeichnet, dass** jeder Treiber (10, 20, 30) durch die gleiche Steuerschaltung (2) gesteuert wird.

13. Steuer- und Leistungsmodul nach einem der vorhergehenden Ansprüche, **dadurch gekennzeichnet, dass** die Treiber (10, 20, 30) jeweils die Leistungstransistoren (11, 12, 21, 22, 31, 32) eines Brückenzweigs (B1, B2, B3) steuern.

14. Steuer- und Leistungsmodul nach dem vorhergehenden Anspruch, **dadurch gekennzeichnet, dass** jeder Brückenzweig mindestens zwei Leistungstransistoren mit jeweils einem Gate umfasst, **und dass** die Treiber (10, 20, 30) ausgangsseitig mit den Gates der beiden Leistungstransistoren (11, 12; 21, 22; 31, 32) desselben Brückenzweiges verbunden sind.

15. Steuer- und Leistungsmodul nach Anspruch 14, **dadurch gekennzeichnet, dass** die Treiber (10, 20, 30) die Phasenpotenziale (ϕ1, ϕ2, ϕ3) des Starter-Generators zur Steuerung des einen Transistors (12, 22, 32) mit dem Massepotenzial des Gleichrichters und zur Steuerung des anderen Transistors (11, 21, 31) mit dem Ausgangspotenzial Ua des Gleichrichters vergleichen.

16. Steuer- und Leistungsmodul nach Anspruch 14 oder 15, **dadurch gekenntzeichnet, dass** die Treiber (10, 20, 30) von der Steuerschaltung (2) ein Signal (ALG) der Versorgung der Gates der Transistoren (11, 12, 21. 22, 31, 32) empfangen.

17. Steuer- und Leistungsmodul nach Anspruch 16, **dadurch gekenntzeichnet, dass** das Versorgungssignal (ALG) von einer Hilfsquelle geliefert wird.

18. Steuer- und Leistungsmodul nach Anspruch 16 oder 17, **dadurch gekennzeichnet, dass** die Spannung des Signals (ALG), das von der Steuerschaltung (2) geliefert wird, 16 Volt +/- 1 Volt beträgt.

19. Steuer- und Leistungsmodul nach einem der Ansprüche 7 bis 18, **dadurch gekennzeichnet, dass** die Treiber (10, 20, 30) von der Steuerschaltung (2) ein Signal (SC) empfangen, das für die Informationen repräsentativ ist, die von den Positionssensoren des Rotors des Starter-Generators geliefert werden, um die Position des Rotors des Starter-Generators anzuzeigen.

20. Steuer- und Leistungsmodul nach einem der Ansprüche 7 bis 18, **dadurch gekennzeichnet, dass** die Treiber (10, 20, 30) von der Steuerschaltung (2) ein Freigabesignal (VA, VD) für den Generatorbetrieb oder den Starterbetrieb des Starter-Generators empfangen.

21. Steuer- und Leistungsmodul nach Anspruch 14, **dadurch gekennzeichnet, dass** die Treiber (10, 20, 30) eine logische Schaltung (13) und Stromquellen (S11, S12) für die Steuerung der Gates der Leistungstransistoren in Abhängigkeit von den an den Eingängen des Treibers empfangenen Signalen umfassen.
